# EUROPEAN PATENT APPLICATION

(11) **EP 4 819 194 A1**
(43) Date of publication of application: **07.10.2026**
(21) Application number: 24897131.9
(22) Date of filing: 17.10.2024
(51) Int. Cl.: H01L 21/02, H01L 21/50, H01L 21/60, H01L 21/677, H01L 21/683

(54) **BONDING SYSTEM AND BONDING METHOD**

(30) Priority: 01.12.2023 JP 2023204119
(71) Applicant: Panasonic Intellectual Property Management Co., Ltd., Kadoma-shi, Osaka 571-0057 (JP)
(72) Inventor: NODA, Kazuhiko, Kadoma-shi, Osaka 571-0057 (JP); HAMAHIRA, Masaru, Kadoma-shi, Osaka 571-0057 (JP); NAGAYASU, Hiroshi, Kadoma-shi, Osaka 571-0057 (JP); IIO, Atsushi, Kadoma-shi, Osaka 571-0057 (JP)
(74) Representative: Grünecker Patent- und Rechtsanwälte PartG mbB
(86) International application number: PCT/JP2024/036997
(87) International publication number: WO 2025/115441

(57) **Abstract**

A bonding system comprises: a loading module configured to load a component carrier holding a plurality of components and to load a substrate to be bonded with the plurality of components; a relay module onto which the component carrier and the substrate received from the loading module are placed; a transport module configured to transport the component carrier and the substrate placed on the relay module along a first direction; a surface treatment module configured to perform surface treatment on the plurality of components held on the component carrier and to perform surface treatment on the substrate; and a bonding apparatus configured to bond the plurality of surface-treated components individually to the surface-treated substrate, wherein the transport module transports the component carrier and the substrate between the surface treatment module and the bonding apparatus.

## Description

### TECHNICAL FIELD

The present disclosure relates to a bonding system and bonding method for bonding a plurality of components held on a component carrier individually to a substrate.

### BACKGROUND ART

Conventionally, with the increasing integration of semiconductor devices, technologies for stacking semiconductor devices three-dimensionally have been proposed. For example, a bonding system for bonding semiconductor wafers together has been proposed (see Patent Document 1).

### PRIOR ART DOCUMENT

### PATENT DOCUMENT

Patent Document 1: Japanese Patent Publication No. 7012798

### SUMMARY OF INVENTION

### TECHNICAL PROBLEM

Bonding is not limited to bonding semiconductor wafers together as in Patent Document 1. For example, it is conceivable to construct a bonding system that individually bonds a plurality of components held on a component carrier (e.g., a tape frame) to a semiconductor wafer substrate. In this case, processing efficiency may decrease, as it is necessary to design the system to avoid interference between transport devices in order to automatically transport two different types of objects, a component carrier and a substrate.

It is an object of the present disclosure to provide a bonding system and bonding method with high processing efficiency.

### MEANS FOR SOLVING PROBLEM

A bonding system of the present disclosure comprises:a loading module configured to load a component carrier holding a plurality of components and to load a substrate to be bonded with the plurality of components; a relay module onto which the component carrier and the substrate received from the loading module are placed; a transport module configured to transport the component carrier and the substrate placed on the relay module along a first direction; a surface treatment module configured to perform surface treatment on the plurality of components held on the component carrier and to perform surface treatment on the substrate; and a bonding apparatus configured to bond the plurality of surface-treated components individually to the surface-treated substrate, wherein the transport module transports the component carrier and the substrate between the surface treatment module and the bonding apparatus.

A bonding method of the present disclosure comprises the steps of: loading, using a loading module, a component carrier configured to hold a plurality of components and a substrate to be bonded with the plurality of components; placing, using a relay module, the component carrier and the substrate received from the loading module; transporting, using a transport module, the component carrier and the substrate placed on the relay module along a first direction; performing, using a surface treatment module, surface treatment on the plurality of components held on the component carrier and surface treatment on the substrate; and bonding, using a bonding apparatus, the plurality of surface-treated components individually to the surface-treated substrate, wherein the transport module transports the component carrier and the substrate between the surface treatment module and the bonding apparatus.

### ADVANTAGEOUS EFFECT OF INVENTION

According to the present disclosure, there can be provided a bonding system and bonding method with high processing efficiency.

### BRIEF DESCRIPTION OF DRAWINGS

Fig. 1A is a schematic plan view of a bonding system in an embodiment.
Fig. 1B is an enlarged view of a bonding apparatus in Fig. 1A.
Fig. 2 is a schematic plan view of a loading module in the embodiment.
Fig. 3 is a schematic plan view of the loading module in the embodiment (with a hand holding a substrate being advanced forward).
Fig. 4 is a schematic plan view of the loading module in the embodiment (with a hand holding a component carrier being advanced forward).
Fig. 5 is a schematic plan view of a transport module in the embodiment.
Fig. 6 is a schematic perspective view of a relay module in the embodiment.
Fig. 7 is a schematic front view of a first temporary placement stage in the embodiment.
Fig. 8 is a schematic front view of a second temporary placement stage in the embodiment.
Fig. 9 is a schematic plan view for illustrating the deliver of a substrate at the first temporary placement stage in the embodiment.
Fig. 10 is a schematic plan view for illustrating the deliver of a component carrier at the second temporary placement stage in the embodiment.
Fig. 11 is a schematic perspective view of a first positioning stage in the embodiment.
Fig. 12 is a schematic perspective view for illustrating a method of using the first positioning stage in the embodiment.
Fig. 13 is a schematic perspective view of a second positioning stage in the embodiment.
Fig. 14 is a schematic perspective view for illustrating a method of using the second positioning stage in the embodiment.
Fig. 15 is a schematic plan view showing the deliver of a substrate at the first positioning stage in the embodiment.
Fig. 16 is a schematic plan view showing the deliver of a component carrier at the second positioning stage in the embodiment.
Fig. 17 is a schematic perspective view of a carrier holding table in the embodiment.
Fig. 18 is a longitudinal sectional view schematically showing a method of holding a component carrier using the carrier holding table in the embodiment.
Fig. 19 is a longitudinal sectional view schematically showing a method of holding a component carrier using the carrier holding table in the embodiment.
Fig. 20 is a longitudinal sectional view schematically showing a method of holding a component carrier using the carrier holding table in the embodiment.
Fig. 21 is a longitudinal sectional view schematically showing a method of holding a component carrier using the carrier holding table in the embodiment.
Fig. 22 is a longitudinal sectional view schematically showing the state in which a substrate is held on a substrate holding table in the embodiment.
Fig. 23 is a longitudinal sectional view schematically showing a method for bonding a component held on a component carrier to a substrate in the embodiment.
Fig. 24 is a longitudinal sectional view schematically showing the method for bonding a component held on a component carrier to a substrate in the embodiment.
Fig. 25 is a plan view of the bonding system schematically showing an example of substrate processing flow in the embodiment.
Fig. 26 is a plan view of the bonding system schematically showing the example of substrate processing flow in the embodiment.
Fig. 27 is a plan view of the bonding system schematically showing the example of substrate processing flow in the embodiment.
Fig. 28 is a plan view of the bonding system schematically showing an example of component carrier processing flow in the embodiment.
Fig. 29 is a plan view of the bonding system schematically showing the example of component carrier processing flow in the embodiment.

### DESCRIPTION OF EMBODIMENTS

### (Aspects of the Present Disclosure)

A first aspect of the present disclosure provides a bonding system comprising: a plurality of surface treatment modules configured to perform surface treatment on a plurality of components held on a component carrier and to perform surface treatment on a substrate to be bonded with the plurality of components; a bonding apparatus configured to bond the plurality of surface-treated components individually to the surface-treated substrate; and a transport module configured to transport the component carrier and the substrate between the surface treatment modules and the bonding apparatus, wherein the transport module includes: a transport robot having a first hand configured to hold the substrate and a second hand configured to hold the component carrier; and a robot transport table configured to move the transport robot along a first direction.

A second aspect of the present disclosure provide the bonding system of the first aspect, wherein at least one of the surface treatment modules and the bonding apparatus are arranged on opposite sides with respect to a movement path of the transport robot along the first direction.

A third aspect of the present disclosure provide the bonding system of the first aspect or second aspect, wherein the surface treatment modules perform surface treatment using any one of ultraviolet rays, plasma, and liquid.

A fourth aspect of the present disclosure provide the bonding system of any one of the first aspect to the third aspect, wherein the component carrier is a tape frame having an ultraviolet-curable adhesive sheet, and at least one of the surface treatment module includes an ultraviolet irradiation device configured to emit ultraviolet rays.

A fifth aspect of the present disclosure provide the bonding system of any one of the first aspect to the fourth fifth aspect, wherein the bonding apparatus includes a first bonding module into which the substrate is loaded and a second bonding module into which the component carrier is loaded, and wherein the first bonding module and the second bonding module are arranged in the first direction.

A sixth aspect of the present disclosure provide the bonding system of any one of the first aspect to the fifth aspect, further including a partition wall that partitions the transport module and the bonding apparatus from each other, wherein the partition wall includes an opening for delivering the component carrier and substrate held by the transport module to the bonding apparatus.

A seventh aspect of the present disclosure provide the bonding system of the sixth aspect, wherein the opening in the partition wall includes a first opening through which the substrate passes and a second opening through which the component carrier passes.

An eighth aspect of the present disclosure provide the bonding system of any one of the first aspect to the seventh aspect, wherein the first hand and the second hand are positioned offset from each other vertically, and each is movable forward and backward.

A ninth aspect of the present disclosure provide the bonding system of the eighth aspect, wherein the first hand is positioned above the second hand.

A tenth aspect of the present disclosure provide the bonding system of any one of the first aspect to the ninth aspect, wherein the substrate is a wafer, and the component carrier is a tape frame.

An eleventh aspect of the present disclosure provides a bonding method comprising: performing surface treatment on a plurality of components held on a component carrier; performing surface treatment on a substrate to be bonded with the plurality of components; transporting the surface-treated substrate to the bonding apparatus with a first hand; transporting the surface-treated component carrier to the bonding apparatus with a second hand; bonding the plurality of surface-treated components individually to the surface-treated substrate, using the bonding apparatus; removing, with the hand, the substrate to which a plurality of components have been bonded from the bonding apparatus; and removing, with the hand, the component carrier from which the plurality of components have been removed, from the bonding apparatus.

### (Other Aspects of the Present Disclosure)

A first aspect of the present disclosure provides a bonding system comprising:a loading module configured to load a component carrier holding a plurality of components and to load a substrate to be bonded with the plurality of components; a relay module onto which the component carrier and the substrate received from the loading module are placed; a transport module configured to transport the component carrier and the substrate placed on the relay module along a first direction; a surface treatment module configured to perform surface treatment on the plurality of components held on the component carrier and to perform surface treatment on the substrate; and a bonding apparatus configured to bond the plurality of surface-treated components individually to the surface-treated substrate, wherein the transport module transports the component carrier and the substrate between the surface treatment module and the bonding apparatus.

A second aspect of the present disclosure provides the bonding system of the first aspect, wherein the relay module includes: a first temporary placement stage onto which the substrate is placed; and a second temporary placement stage onto which the component carrier is placed.

A third aspect of the present disclosure provides the bonding system of the second aspect, wherein the first temporary placement stage has a first shelf for placing the pre-use substrate received from the loading module, and a second shelf for placing the post-use substrate on which the plurality of components have been bonded, and wherein the second temporary placement stage has a third shelf for placing the pre-use component carrier received from the loading module, and a fourth shelf for placing the post-use component carrier from which the plurality of components have been removed.

A fourth aspect of the present disclosure provides the bonding system of the third aspect, wherein the first shelf is disposed below the second shelf, and the third shelf is disposed below the fourth shelf.

A fifth aspect of the present disclosure provides the bonding system of any one of the second to fourth aspects, wherein the first temporary placement stage is configured to deliver the substrate to the transport module in a first deliver direction in plan view, and the second temporary placement stage is configured to deliver the component carrier to the transport module in a second deliver direction in plan view.

A sixth aspect of the present disclosure provides the bonding system of the fifth aspect, wherein the first temporary placement stage and the second temporary placement stage are arranged in a second direction that intersects the first direction in plan view, and wherein the first deliver direction and the second deliver direction each intersect with the first direction.

A seventh aspect of the present disclosure provides the bonding system of any one of the second to sixth aspects, wherein the relay module further includes a positioning stage for receiving the component carrier and the substrate from the transport module and positioning them in their respective predetermined directions.

An eighth aspect of the present disclosure provides the bonding system of the seventh aspect, wherein the positioning stage includes: a first positioning stage for positioning the substrate; and a second positioning stage for positioning the component carrier.

A ninth aspect of the present disclosure provides the bonding system of seventh or eighth aspect, wherein the positioning stage is disposed below the first temporary placement stage and the second temporary placement stage.

A tenth aspect of the present disclosure provides the bonding system of the first to ninth aspects, wherein the loading module includes: a first transport robot having a first hand for holding the substrate and a second hand for holding the component carrier; and a first robot movement table configured to move the first transport robot in a second direction intersecting the first direction in plan view.

An eleventh aspect of the present disclosure provides the bonding system of any one of the first to tenth aspects, wherein the transport module includes: a second transport robot having a third hand for holding the substrate and a fourth hand for holding the component carrier; and a second robot movement table configured to move the second transport robot in the first direction.

A twelfth aspect of the present disclosure provides the bonding system of the eleventh aspect, wherein at least one surface treatment module and the bonding apparatus are arranged on opposite sides with respect to the movement path of the transport module along the first direction.

A thirteenth aspect of the present disclosure provides the bonding system of any one of the first to twelfth aspects, wherein the substrate is a wafer and the component carrier is a tape frame.

A fourteenth aspect of the present disclosure provides a bonding method comprising: loading a component carrier configured to hold a plurality of components and a substrate to be bonded with the plurality of components, by using a loading module; placing the component carrier and the substrate received from the loading module, by using a relay module; transporting the component carrier and the substrate placed on the relay module along a first direction, by using a transport module; performing surface treatment on the plurality of components held on the component carrier and surface treatment on the substrate, by using a surface treatment module; and bonding the plurality of surface-treated components individually to the surface-treated substrate, by using a bonding apparatus, wherein the transport module transports the component carrier and the substrate between the surface treatment module and the bonding apparatus.

### (Embodiment)

Hereinafter, an exemplary embodiment of the bonding system and bonding method according to the present disclosure will be described with reference to the accompanying drawings. The present disclosure is not limited to specific configurations of the embodiment described below, but includes configurations based on similar technical ideas.

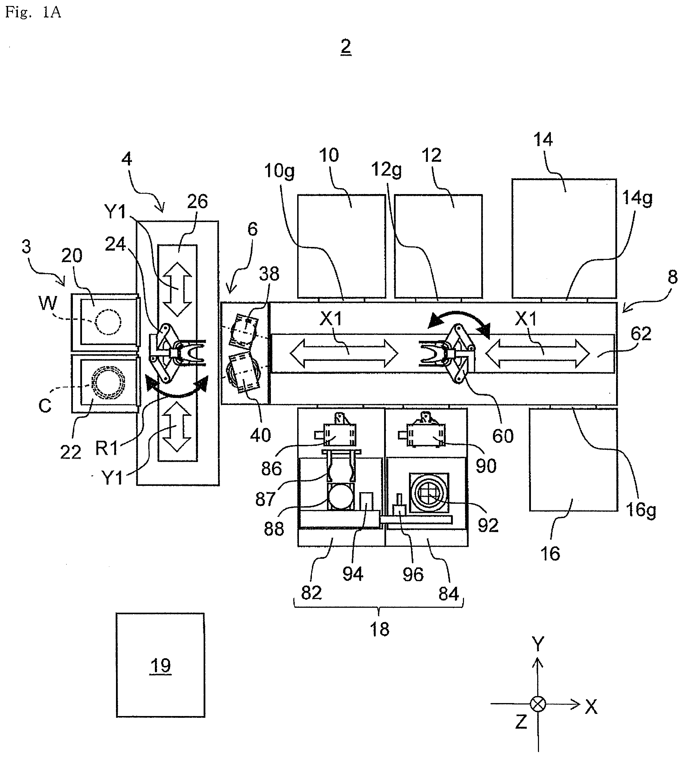

First, a bonding system 2 and bonding method of the embodiment of the present disclosure will be described with reference to Fig. 1A. Fig. 1A is a schematic plan view showing the bonding system 2 in a simplified manner.

The bonding system 2 shown in Fig. 1A is a system for individually bonding a plurality of components (not shown) held on a component carrier C to a substrate W. In this embodiment, the components are chip type components, the component carrier C is a tape frame having an adhesive sheet that adhesively holds a plurality of components together, and the substrate W is a semiconductor wafer. The tape frame may also be called a dicing frame or wafer ring, for example.

The bonding system 2 comprises a load port 3, a loading module 4, a relay module 6, a transport module 8, a plurality of surface treatment modules 10, 12, 14, and 16, a bonding apparatus 18, and a control unit 19. In Fig. 1A, the mutually orthogonal horizontal directions are defined as the X-axis and Y-axis directions, and the vertical direction orthogonal to both the X-axis and Y-axis directions is defined as the Z-axis direction.

The bonding system 2 shown in Fig. 1A is disposed in a cleanroom, and a downflow flows through the inside of the bonding system 2.

The load port 3 is a unit for supplying a substrate W and a component carrier C to the loading module 4. The load port 3 is mounted with a sealed container 20 containing a plurality of substrates W and a sealed container 22 containing a plurality of component carriers C. Fig. 1A exemplifies the state in which substrates W are contained in the sealed container 20 and component carriers C are contained in the sealed container 22. In the example shown in Fig. 1A, the sealed containers 20 and 22 are arranged in the Y-axis direction and coupled to the loading module 4 in the X-axis direction.

The loading module 4 is a module for loading a substrate W and component carrier C supplied from the load port 3 into the bonding system 2. The loading module 4 removes a substrate W from the sealed container 20 mounted on the load port 3 and removes a component carrier C from the sealed container 22. The loading module 4 may also be called an equipment front end module (EFEM).

The loading module 4 includes a transport robot 24 and a robot movement table 26.

The transport robot 24 is a robot for transporting a substrate W and component carrier C supplied from the load port 3. The transport robot 24 has arms for holding a substrate W and a component carrier C, respectively, and is moved by the robot movement table 26.

The robot movement table 26 is a drive table for moving the transport robot 24. The robot movement table 26 in this embodiment has the function of moving the transport robot 24 linearly in the Y-direction (see arrow Y1), the function of rotating the transport robot 24 horizontally (see arrow R1), and the function of raising and lowering the transport robot 24 in the Z direction. Note that the functions of horizontally rotating and raising and lowering the transport robot 24 may be implemented by a swivel mechanism and a lifting mechanism disposed on the transport robot 24.

The transport robot 24 moves in the Y-axis direction to access each of the sealed containers 20 and 22, which are arranged in the Y-axis direction, and removes a substrate W from the sealed container 20 and a component carrier C from the sealed container 22.

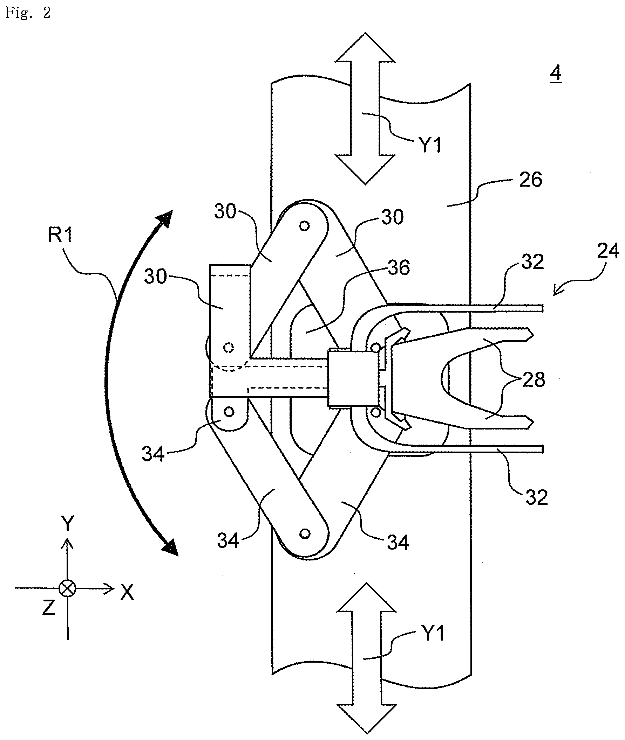

The detailed configuration of the loading module 4 will next be described using Figs. 2 to 4.

Figs. 2 to 4 are schematic plan views showing different states of the transport robot 24 in the loading module 4.

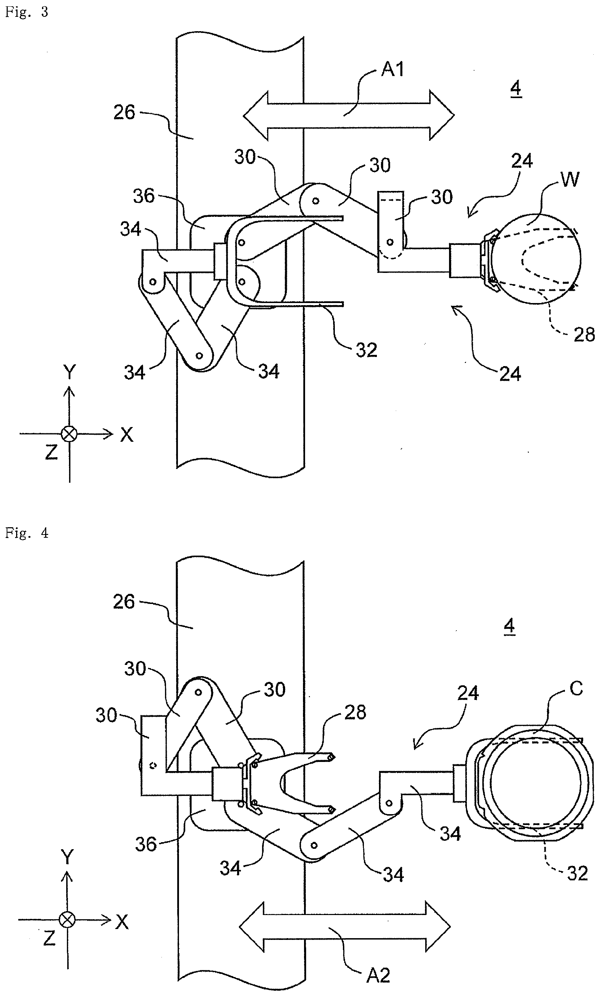

Fig. 2 shows the state in which a hand 28 of the transport robot 24 holds neither a substrate W nor a component carrier C, Fig. 3 shows the state in which the hand 28 holding a substrate W has moved forward, and Fig. 4 shows the state in which a hand 32 holding a component carrier C has moved forward.

As shown in Figs. 2 to 4, the transport robot 24 includes the hand 28 and an arm 30 for holding and transporting a substrate W, and the hand 32 and an arm 34 for holding and transporting a component carrier C.

As shown in Fig. 2, the hand 28 is a hand capable of supporting a substrate W from below and has a bifurcated shape. The hand 28 has on its upper surface a plurality of anti-slip portions (not shown) to prevent positional displacement of the substrate W. The hand 28 may also be a hand that chucks the substrate W from above (including a non-contact method). The hand 28 is attached to the distal end of a plurality of arms 30. The plurality of arms 30 are pivotally supported so as to be rotatable relative to each other, and their proximal end is pivotally supported on a base 36. As shown in Fig. 3, the hand 28 moves linearly in the front-rear direction by being driven so that the coupling angles between the plurality of arms 30 change (see arrow A1).

As shown in Fig. 2, the hand 32 is a hand capable of supporting a component carrier C from below and has a bifurcated shape. The hand 32 has on its upper surface a plurality of anti-slip portions (not shown) to prevent the positional displacement of a component carrier C. The hand 32 is attached to the distal end of a plurality of arms 34. The plurality of arms 34 are pivotally supported so as to be rotatable relative to each other, and their proximal end is pivotally supported on the base 36. As shown in Fig. 4, the hand 32 moves linearly in the front-rear direction by being driven so that the coupling angles between the plurality of arms 34 change (see arrow A2).

The hand 28 and arm 30 for transporting a substrate W and the hand 32 and arm 34 for transporting a component carrier C are arranged vertically offset from each other to prevent interference. In this embodiment, the hand 28 for substrate is positioned above the hand 32 for component carrier. Since the particle adhesion rate is higher on the component carrier C than on the substrate W, positioning the hand 32 for component carrier lower can suppress particle ingress.

The hand 32, positioned below the hand 28, is positioned at a height that allows it to pass through the vertical gap in the arm 30 coupled to the hand 28. This allows the hand 28 and arm 30 for substrate and the hand 32 and arm 34 for component carrier to move independently without interfering with each other.

Returning to Fig. 2, the robot movement table 26 moves the base 36 along the Y-axis, thereby moving the transport robot 24 integrally along the Y-axis (arrow Y1). The robot movement table 26 rotationally drives the base 36 around a rotation axis extending in the Z-axis direction, thereby horizontally rotating the transport robot 24 integrally (arrow R1). The robot movement table 26 raises and lowers the base 36 along the Z-axis, thereby raising and lowering the transport robot 24 integrally.

The transport robot 24 in this embodiment does not have the function of moving in a horizontal direction (for example, the X-axis direction) other than the Y-axis direction. That is, the linear horizontal movement of the transport robot 24 is limited to the Y-axis direction only. This makes it possible to reduce the dimensions of the loading module 4 in the X-axis direction.

Returning to Fig. 1A, the relay module 6 is coupled to the downstream side of the loading module 4, and the transport module 8 is coupled to the downstream side of the relay module 6.

The transport module 8, like the loading module 4, includes a transport robot 60 and a robot movement table 62. The transport robot 60 has the same configuration as the transport robot 24, and the robot movement table 62 has the same configuration as the robot movement table 26.

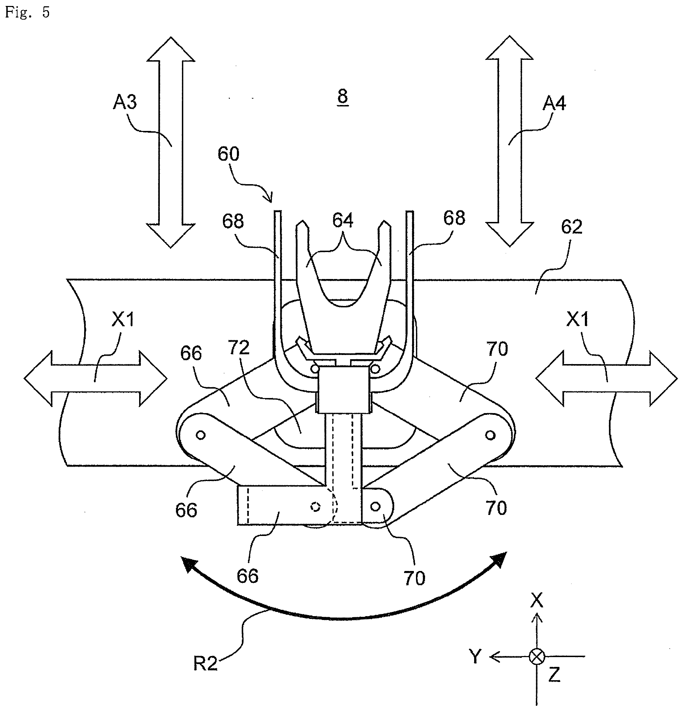

The detailed configuration of the transport robot 60 and the robot movement table 62 will be described using Fig. 5.

Fig. 5 is a schematic plan view of the transport module 8.

As shown in Fig. 5, the transport robot 60 of the transport module 8 includes a hand 64 and an arm 66 for holding and transporting a substrate W, and a hand 68 and an arm 70 for holding and transporting a component carrier C.

As shown in Fig. 5, the hand 64 is a hand capable of supporting a substrate W from below and is attached to the distal end of a plurality of arms 66. The hand 68 may be one that chucks the substrate W from above (including a non-contact method). The proximal end of the plurality of arms 66 is pivotally supported on a base 72. The hand 64 moves linearly in the front-rear direction (see arrow A3) by being driven so that the coupling angles between the plurality of arms 66 change.

The hand 68 is a hand capable of supporting a component carrier C from below and is attached to the distal end of a plurality of arms 70. The proximal end of the plurality of arms 70 is pivotally supported on the base 72. The hand 68 moves linearly in the front-rear direction (see arrow A4) by being driven so that the coupling angles between the plurality of arms 70 change.

The hand 64 and arm 66 for transporting a substrate W and the hand 68 and arm 70 for transporting a component carrier C are arranged vertically offset from each other so as not to interfere with each other. In this embodiment, the hand 64 for substrate is positioned above the hand 68 for component carrier.

The robot movement table 62 moves the base 72 along the X-axis, thereby moving the transport robot 60 integrally along the X-axis (arrow X1). The robot movement table 62 rotationally drives the base 72 around a rotation axis extending in the Z-axis direction, thereby horizontally rotating the transport robot 60 integrally (arrow R2). The robot movement table 62 raises and lowers the base 72 along the Z-axis direction, thereby raising and lowering the transport robot 60 integrally. Note that the functions of horizontally rotating and raising and lowering the transport robot 60 may be implemented by a swivel mechanism and a lifting mechanism disposed on the transport robot 60.

The transport robot 60 in this embodiment does not have the function to move in a horizontal direction (for example, the Y-axis direction) other than the X-axis direction, and linear horizontal movement is limited to the X-axis direction only. This makes it possible to reduce the dimensions of the transport module 8 in the Y-axis direction.

Returning to Fig. 1A, the relay module 6 is a module that temporarily holds a substrate W and a component carrier C loaded into the loading module 4 and then hands them over to the transport module 8.

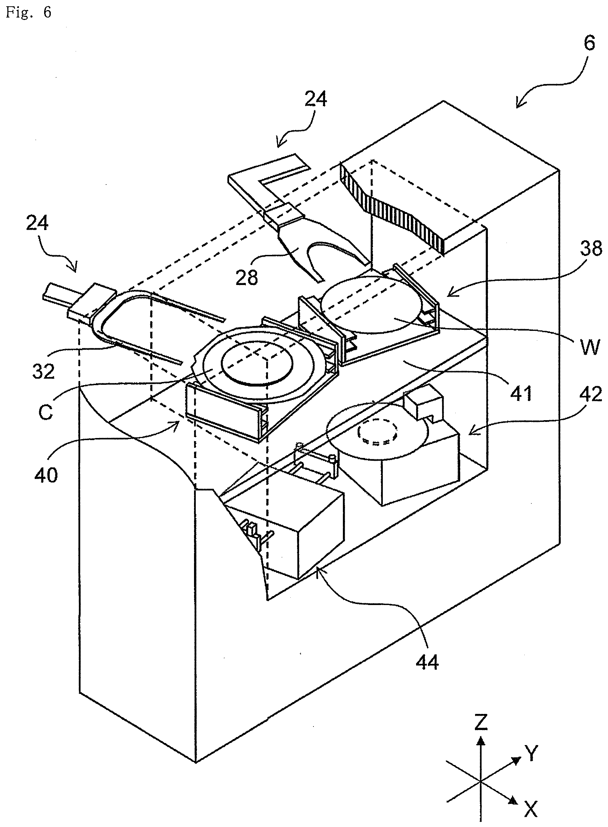

Fig. 6 is a perspective view schematically showing the relay module 6.

As shown in Fig. 6, the relay module 6 includes a first temporary placement stage 38 and a second temporary placement stage 40.

The first temporary placement stage 38 is a stage for placing a pre-use substrate W loaded from the loading module 4. The transport robot 24 of the loading module 4 described above places a substrate W held in its hand 28 onto the first temporary placement stage 38, thereby temporarily placing the pre-use substrate W on the first temporary placement stage 38. The temporarily placed substrate W is then received and transported by the transport robot 60 (not shown) of the transport module 8.

The second temporary placement stage 40 is a stage for placing a pre-use component carrier C loaded from the loading module 4. The transport robot 24 of the loading module 4 described above places a component carrier C held in its hand 32 onto the second temporary placement stage 40, thereby temporarily placing the component carrier C on the second temporary placement stage 40. The temporarily placed component carrier C is then received and transported by the transport robot 60 (not shown) of the transport module 8.

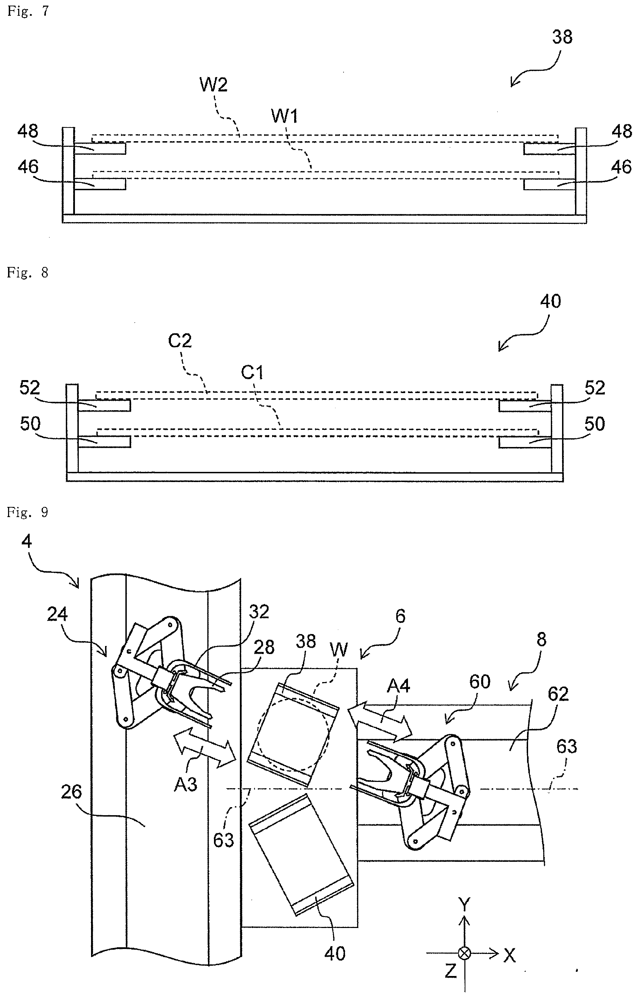

Fig. 7 is a schematic front view of the first temporary placement stage 38, and Fig. 8 is a schematic front view of the second temporary placement stage 40.

The first temporary placement stage 38 shown in Fig. 7 includes two shelves 46 and 48 for placing the substrate W.

The lower first shelf 46 is a shelf for temporarily placing a pre-use substrate W1 loaded from the loading module 4. The upper second shelf 48 is a shelf for temporarily placing a post-use substrate W2 onto which components are bonded by the bonding apparatus 18 described later.

By providing the second shelf 48 in addition to the first shelf 46, the post-use substrate W2 with bonded components can be returned to the loading module 4 via the relay module 6 and discharged to the exterior of the bonding system 2.

By arranging the first shelf 46 and the second shelf 48 vertically, the horizontal dimensions of the relay module 6 can be reduced. By placing the pre-use substrate W1, which has a relatively higher particle content than the post-use substrate W2, on the lower first shelf 46, particle ingress can be suppressed.

The second temporary placement stage 40 shown in Fig. 8 has two shelves 50 and 52 as shelves for arranging component carriers C.

The lower third shelf 50 is a shelf for temporarily placing a pre-use component carrier C1 loaded into the loading module 4. The upper fourth shelf 52 is a shelf for temporarily placing a post-use component carrier C2 from which components are removed in the bonding apparatus 18 described later.

By providing the fourth shelf 52 in addition to the third shelf 50, the post-use component carrier C2, after the components are bonded, can be returned to the loading module 4 via the relay module 6 and discharged to the exterior of the bonding system 2.

By arranging the third shelf 50 and the fourth shelf 52 vertically, the horizontal dimensions of the relay module 6 can be reduced. By placing the pre-use component carrier C1, which has a relatively higher particle content than the post-use component carrier C2, on the lower third shelf 50, particle ingress can be suppressed.

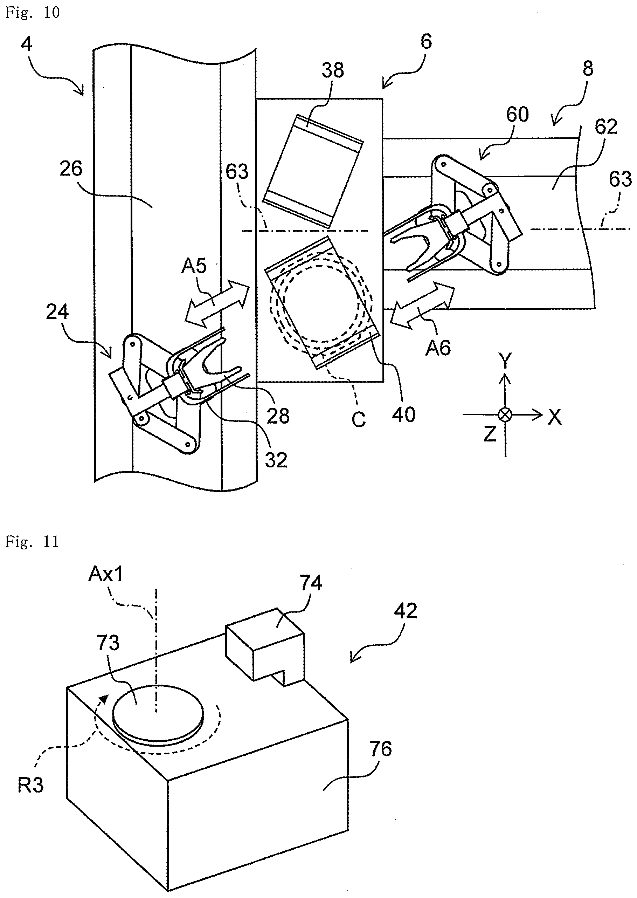

Returning to Fig. 6, the temporary placement stages 38 and 40 in this embodiment are arranged in an oblique orientation so as to intersect both the X-axis and Y-axis directions in plan view. The arrangement of the temporary placement stages 38 and 40 will now be described using Figs. 9 and 10.

Figs. 9 and 10 are schematic plan views showing the area around the relay module 6 including the first temporary placement stage 38 and the second temporary placement stage 40.

Fig. 9 shows the state in which the substrate W placed on the first temporary placement stage 38 is being transported, and Fig. 10 shows the state around the time of the transport of a component carrier C placed on the second temporary placement stage 40.

As shown in Figs. 9 and 10, the first temporary placement stage 38 and the second temporary placement stage 40 are arranged in the Y-axis direction and are positioned on opposite sides of a central axis 63 of the movement path of the downstream transport robot 60 along the X-axis direction.

As shown in Fig. 9, the first temporary placement stage 38 is configured to deliver a substrate W to the upstream transport robot 24 along an oblique deliver direction A3 in plan view, and to deliver a substrate W to the downstream transport robot 60 along an oblique deliver direction A4 in plan view. In this embodiment, the deliver directions A3 and A4 are directions intersecting both the X-axis and Y-axis directions in plan view and are parallel to each other. In particular, the deliver direction A4 to the downstream transport robot 60 is inclined in a direction that approaches the central axis 63 of the movement path of the transport robot 60.

As shown in Fig. 10, the second temporary placement stage 40 is configured to deliver a component carrier C to the upstream transport robot 24 along an oblique deliver direction A5 in plan view, and to deliver a component carrier C to the downstream transport robot 60 along an oblique deliver direction A6 in plan view. In this embodiment, the deliver directions A5 and A6 are directions intersecting both the X-axis and Y-axis directions in plan view and are parallel to each other. In particular, the deliver direction A6 to the downstream transport robot 60 is inclined in a direction toward the central axis 63 of the movement path of the transport robot 60.

By virtue of setting the deliver directions A4 and A6 in this manner, even if the downstream transport robot 60 is only capable of horizontal movement in the X-axis direction and does not have the function to move in the Y-axis direction, the transport robot 60 can receive a substrate W from the first temporary placement stage 38 and a component carrier C from the second temporary placement stage 40 by rotating horizontally. This simplifies the configuration of the transport module 8 and improves processing efficiency. Furthermore, with this configuration, a less expensive 3-axis type of transport robot 60 can be used instead of a 4-axis type with a higher degree of freedom of movement for the hand 64, thus contributing to cost reduction.

The inclination angles of the deliver directions A3, A4, A5, and A6 with respect to the central axis 63 need only to be set appropriately according to the specifications of the bonding system 2.

The upstream transport robot 24 is movable in the Y-axis direction to a position where a substrate W can be handed over between it and the first temporary placement stage 38, and to a position where a component carrier C can be handed over between it and the second temporary placement stage 40.

Returning to Fig. 6, the relay module 6 further includes a first positioning stage 42 and a second positioning stage 44.

The first positioning stage 42 is a stage for aligning a substrate W transported by the transport robot 60 of the transport module 8 to a predetermined orientation. The transport robot 60 places a substrate W held in the hand 64 onto the first positioning stage 42, thereby temporarily placing the substrate W on the first positioning stage 42 before bonding. The substrate W placed on the first positioning stage 42 is positioned in a predetermined orientation, handed over to the transport robot 60, and then transported to the bonding apparatus 18.

The second positioning stage 44 is a stage for aligning a component carrier C transported by the transport robot 60 of the transport module 8 to a predetermined orientation. The transport robot 60 places a component carrier C held in the hand 68 onto the second positioning stage 44, thereby temporarily placing the component carrier C on the second positioning stage 44 before bonding. The component carrier C placed on the second positioning stage 44 is positioned to a predetermined orientation, handed over to the transport robot 60, and then transported to the bonding apparatus 18.

By providing the temporary placement stages 42 and 44, the substrate W and component carrier C can be aligned to their respective predetermined orientations just before being transported to the bonding apparatus 18, which leads to improved bonding accuracy in the bonding apparatus 18.

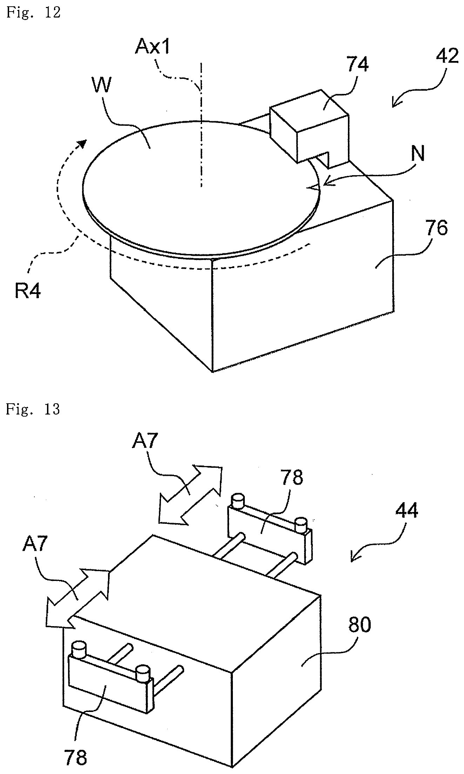

Figs. 11 and 12 are perspective views illustrating the usage of the first positioning stage 42.

As shown in Figs. 11 and 12, the first positioning stage 42 includes a rotating plate 73 (Fig. 11), a rotational position detection unit 74, and a drive box 76.

The rotating plate 73 is a member for rotating a substrate W. The rotating plate 73 is rotatable about a rotation axis Ax1 extending in the Z-axis direction (arrow R3), and as shown in Fig. 12, it rotates with a substrate W placed thereon, allowing the substrate W to rotate (arrow R4).

The rotation position detection unit 74 is a unit for detecting the rotational position of a substrate W. In this embodiment, the rotation position detection unit 74 detects the rotational position of a substrate W by irradiating light toward the outer periphery of the substrate W and detecting light passing through positions corresponding to notches N disposed on the substrate W. The detection method is not limited to this method, and any detection method capable of detecting the rotational position of a substrate W may be adopted.

The drive box 76 is a box-shaped unit that houses a drive unit for the rotating plate 73 and the rotation position detection unit 74. The drive box 76 is coupled to the control unit 19 shown in Fig. 1A. The control unit 19 determines the rotation position of a substrate W based on the result of detection by the rotation position detection unit 74 and adjusts the amount of rotation of the rotating plate 73 so that the rotation position reaches a predetermined rotation position. This positions the substrate W in a predetermined orientation.

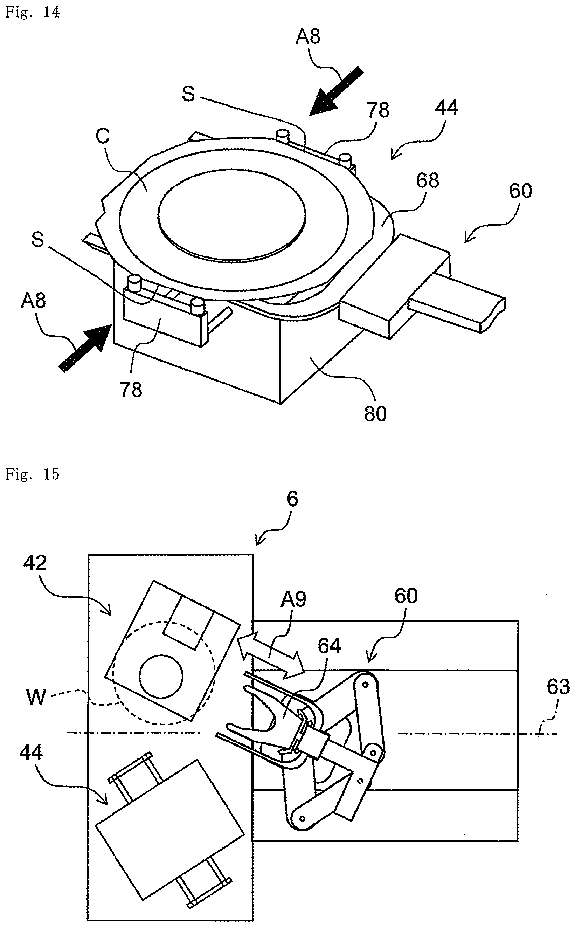

Figs. 13 and 14 are perspective views illustrating the usage of the second positioning stage 44.

As shown in Figs. 13 and 14, the second positioning stage 44 includes a pair of aligners 78 and a drive box 80.

The pair of aligners 78 are members for positioning a component carrier C. The pair of aligners 78 are movable in directions toward and away from each other (arrow A7), and when they move toward each other, they clamp the component carrier C to position it in a predetermined orientation.

The drive box 80 is a box-shaped unit that houses a drive unit for the aligners 78. The drive box 80 is coupled to the control unit 19 shown in Fig. 1A.

As shown in Fig. 14, with the pair of aligners 78 open, the transport robot 60 places a component carrier C held by the hand 68 between the pair of aligners 78. Subsequently, the pair of aligners 78 move in the closing direction (arrow A8), engaging with straight sections S of the component carrier C to clamp the component carrier C, thereby positioning the component carrier C in a predetermined orientation.

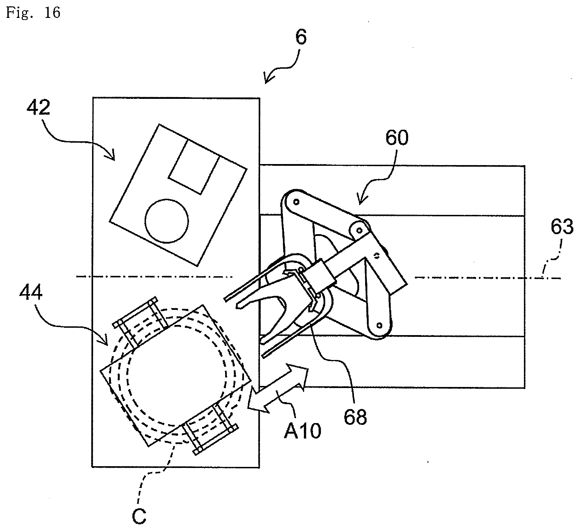

Figs. 15 and 16 are schematic plan views showing the area around the relay module 6 including the first positioning stage 42 and the second positioning stage 44.

Fig. 15 shows the state in which a substrate W is handed over at the first positioning stage 42, and Fig. 16 shows the state in which a component carrier C is handed over at the second positioning stage 44.

The first positioning stage 42 and the second positioning stage 44 are positioned obliquely in plan view, similar to the temporary placement stages 38 and 40 shown in Figs. 9 and 10. As shown in Figs. 15 and 16, the positioning stages 42 and 44 are positioned on opposite sides of the central axis 63 of the movement path along the X-axis of the downstream transport robot 60.

As shown in Fig. 15, the first positioning stage 42 is configured to deliver a substrate W to the transport robot 60 along a deliver direction A9 that is oblique in plan view. The deliver direction A9 of the first positioning stage 42 is parallel to the deliver direction A4 (Fig. 9) of the first temporary placement stage 38.

As shown in Fig. 16, the second positioning stage 44 is configured to deliver a component carrier C to the transport robot 60 along a deliver direction A10 that is oblique in plan view. The deliver direction A10 of the second positioning stage 44 is parallel to the deliver direction A6 (Fig. 10) of the second temporary placement stage 40.

Returning to Fig. 6, the temporary placement stages 38 and 40 are positioned on the upper level, and the positioning stages 42 and 44 are positioned on the lower level. The relay module 6 includes a support plate 41 that supports the temporary placement stages 38 and 40, and the support plate 41 partitions the temporary placement stages 38 and 40 from the positioning stages 42 and 44 vertically. This vertical arrangement reduces the floor area of the relay module 6 and suppresses particle ingress. Furthermore, since the positioning stages 42 and 44 have movable parts inside, there is concern about particles generated due to friction of moving portions. However, by arranging the positioning stages 42 and 44 below the support plate 41 that partitions the space vertically, the possibility of particles adhering to the substrate W and component carrier C on the temporary placement stages 38 and 40 can be reduced.

Returning to Fig. 1A, the control unit 19 is a unit that controls each element of the bonding system 2. The control unit 19 is composed of, for example, a microcomputer that includes a processor and a memory that stores a computer program executed by the processor.

The surface treatment modules 10, 12, 14, and 16 are modules for performing surface treatment on a substrate W and component carrier C. Surface treatment is performed on a substrate W and component carrier C in the surface treatment modules 10, 12, 14, and 16, and then bonding is performed in the bonding apparatus 18.

In this embodiment, three surface treatment modules 10, 12, and 14 are arranged on one side (+Y-axis direction) of the movement path of the transport robot 60, and one surface treatment module 16 is arranged on the other side (-Y-axis direction).

In this embodiment, the surface treatment modules 10 and 12 include cleaning devices for cleaning, the surface treatment module 14 includes a plasma treatment device for surface modification, and the surface treatment module 16 includes a UV irradiation device for curing the adhesive sheet of the component carrier C.

The cleaning device of the surface treatment module 10 cleans the surfaces of a substrate W and component carrier C using a predetermined liquid (for example, pure water, alkaline chemical solution, or neutral surfactant).

The cleaning device of the surface treatment module 12 cleans (rinses) the surfaces of a substrate W and component carrier C using a predetermined liquid (for example, pure water).

The plasma treatment device of the surface treatment module 14 activates the surfaces of a substrate W and component carrier C by irradiating them with plasma.

The UV irradiation device of the surface treatment module 16 irradiates the component carrier C with ultraviolet rays to harden the surface of the adhesive sheet holding components on the component carrier C, thereby weakening its adhesive strength.

By arranging the surface treatment modules 10, 12, 14, and 16 at positions adjacent to the transport path of the transport robot 60, the transport robot 60 can move in the X-axis direction to access each module to load and unload a substrate W and component carrier C.

Each of the surface treatment modules 10, 12, 14, and 16 includes a partition wall to define each module, an opening in the partition wall disposed at a location facing the transport path of the transport robot 60, and a shutter for opening and closing the opening. The opening of each module is closed except when loading or unloading a substrate W or component carrier C, and the shutter operates to open the opening only when loading or unloading a substrate W or component carrier C.

The bonding apparatus 18 is also disposed at a location adjacent to the transport path of the transport robot 60.

The bonding apparatus 18 is an apparatus for individually bonding a plurality of components held by a component carrier C to a substrate W. The bonding apparatus 18 in this embodiment comprises a first bonding module 82 and a second bonding module 84.

The first bonding module 82 is a module that receives a substrate W from the transport robot 60. The second bonding module 84 is a module that receives a component carrier C from the transport robot 60.

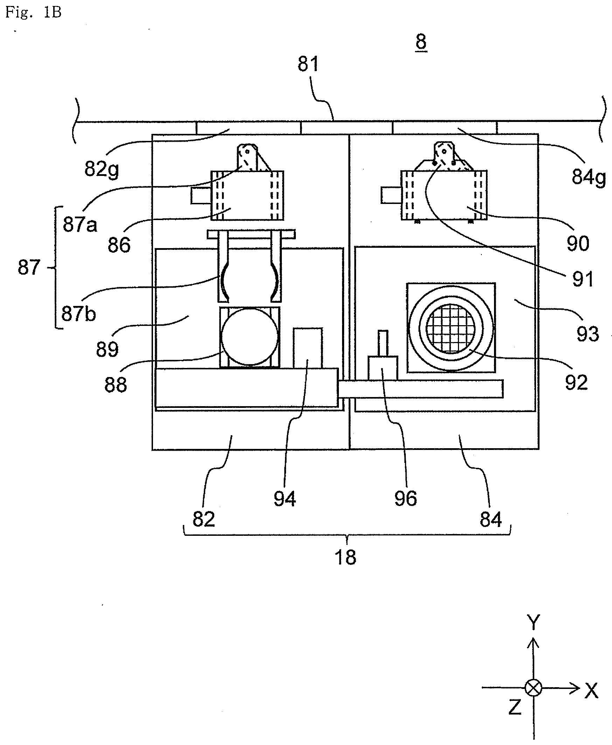

As shown in the enlarged view of Fig. 1B, a partition wall 81 is disposed between the transport module 8 and the bonding apparatus 18. The bonding modules 82 and 84 include openings 82g and 84g in the partition wall 81, respectively, arranged at locations facing the transport path of the transport robot 60, and shutters (not shown) for opening and closing the openings 82g and 84g, respectively. The bonding module 82 includes the first opening 82g for loading and unloading a substrate W, and the bonding module 84 includes the second opening 84g for loading and unloading a component carrier C.

The bonding modules 82 and 84 are arranged adjacent to each other in the X-axis direction that is the direction of movement of the transport robot 60, and their internal spaces are in communication with each other.

The first bonding module 82 includes a substrate temporary placement section 86, a substrate transport device 87, a substrate holding table 88, a stage moving device 89, and a bonding head 94.

The substrate temporary placement section 86 is a member for arranging and temporarily placing a substrates W received from the transport robot 60. The substrate transport device 87 is a device for transporting a substrate W placed in the substrate temporary placement section 86 and delivering the substrate W to the substrate holding table 88. The substrate transport device 87 shown in Fig. 1B comprises a first substrate transport device 87a and a second substrate transport device 87b. The first substrate transport device 87a transports a substrate S placed in the substrate temporary placement section 26 and hands over the substrate S to the second substrate transport device 87b. The second substrate transport device 87b hands over the substrate S received from the first substrate transport device 87a to the substrate holding table 88.

The substrate holding table 88 is a table that holds the substrate W received from the substrate transport device 87 and holds the substrate W while the bonding head 94 performs component bonding. The stage moving device 89 is a device that moves the substrate holding table 88. The bonding head 94 is a unit that receives a component from a pickup head 96 (described later) and bonds the received component to the substrate W. The bonding head 94 in this embodiment is movable along the X-axis direction that is the direction of arrangement of the bonding modules 82 and 84.

The second bonding module 84 includes a carrier temporary placement section 90, a carrier transport device 91, a carrier holding table 92, a stage moving device 93, and the pickup head 96.

The carrier temporary placement section 90 is a member for arranging and temporarily placing a component carrier C received from the transport robot 60. The carrier transport device 91 is a device for transporting the component carrier C placed in the carrier temporary placement section 90 and delivering the component carrier C to the carrier holding table 92. The carrier holding table 92 is a table that holds the component carrier C received from the carrier transport device 91 and holds the component carrier C while the pickup head 96 picks up a component. The stage moving device 93 is a device for moving the carrier holding table 92. The pickup head 96 is a unit for receiving a component from the component carrier C held on the carrier holding table 92 and delivering the received component to the bonding head 94 described above.

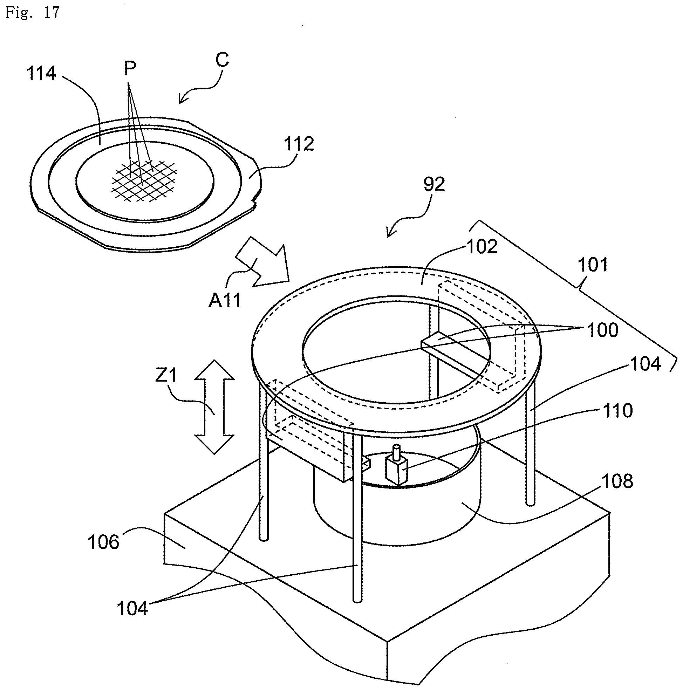

Here, the detailed configuration and operation of the carrier holding table 92 will be described using Figs. 17 to 21.

Fig. 17 is a perspective view schematically showing the carrier holding table 92.

As shown in Fig. 17, the carrier holding table 92 includes a carrier frame guide 100, a carrier frame retainer 102, a plurality of support columns 104, a drive box 106, a seat expansion ring 108, and an ejector 110.

The carrier frame guide 100 is a member that supports a carrier frame 112 of the component carrier C. The component carrier C has the outer carrier frame 112 and an inner adhesive sheet 114, and a plurality of components P are held on the adhesive sheet 114. The transport device not shown (carrier transport device 91 shown in Fig. 1B) transports the component carrier C to the carrier frame guide 100 (arrow A11), and the carrier frame guide 100 supports the carrier frame 112 of the component carrier C.

The carrier frame retainer 102 is a member for pressing the carrier frame 112 of the component carrier C from above. The carrier frame retainer 102 has a ring shape with an open center, and the dimensions of the opening are larger than the dimensions of the adhesive sheet 114.

The support columns 104 are members that support the carrier frame retainer 102 from below, and a plurality of columns are provided. The support columns 104 are configured to be able to move up and down by the drive box 106. When the drive box 106 moves the support columns 104 up and down, the carrier frame guide 100, the carrier frame retainer 102, and the support columns 104 move up and down together (arrow Z1). The carrier frame guide 100, the carrier frame retainer 102, and the support columns 104 constitute a lifting section 101.

The drive box 106 is a box that houses a drive unit for raising and lowering the lifting section 101.

The sheet expansion ring 108 is a member that supports the adhesive sheet 114 inside the component carrier C from below and extends it outward. When the component carrier C supported by the carrier frame guide 100 descends, the adhesive sheet 114 of the component carrier C comes into contact with and is supported by the sheet expansion ring 108. The sheet expansion ring 108 has a cylindrical shape that extends in the Z-axis direction, and the ring portion at its upper end supports the adhesive sheet 114.

The ejector 110 is a member that comes into abutment from below against the adhesive sheet 114 supported by the sheet expansion ring 108 to force a component at a predetermined position upward, thereby assisting in the pickup of the component by the pickup head 96. The ejector 110 is raised and lowered by the drive box 106 independently of the lifting section 101.

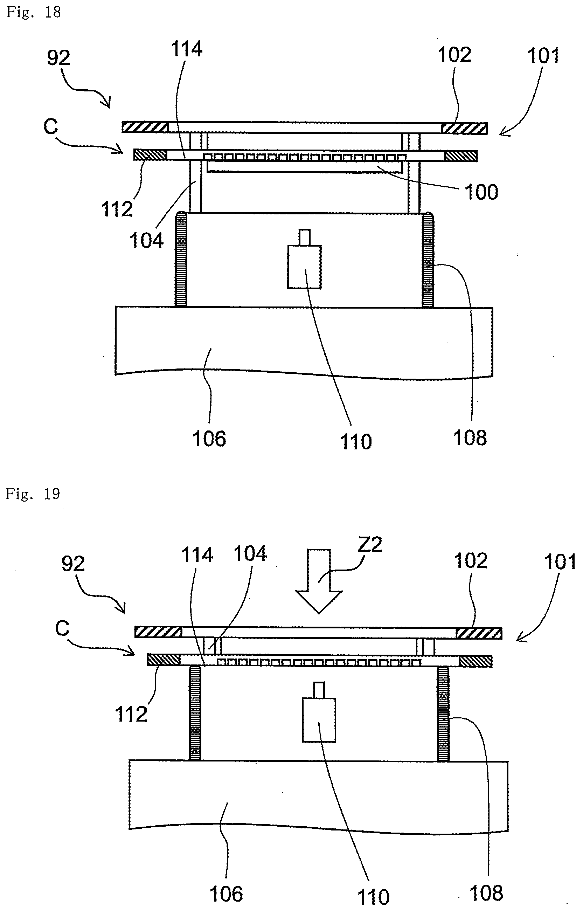

A method for holding a component carrier C using the carrier holding table 92 having the above configuration will be described with reference to Figs. 18 to 21. Figs. 18 to 21 are longitudinal sectional views that schematically show the method for holding a component carrier C using the carrier holding table 92.

As shown in Fig. 18, the transport device not shown (carrier transport device 91 shown in Fig. 1B) transports a component carrier C, allowing the carrier frame guide 100 to support the carrier frame 112 of the component carrier C.

As shown in Fig. 19, the lifting section 101 is lowered (arrow Z2). As a result, the component carrier C supported by the carrier frame guide 100 and the lifting section 101 descend together, and the adhesive sheet 114 of the component carrier C comes into contact with the upper end of the sheet expansion ring 108. When the lifting section 101 is lowered further from this state, the carrier frame 112 of the component carrier C separates from the carrier frame guide 100, and the descending carrier frame retainer 102 comes into contact with the carrier frame 112.

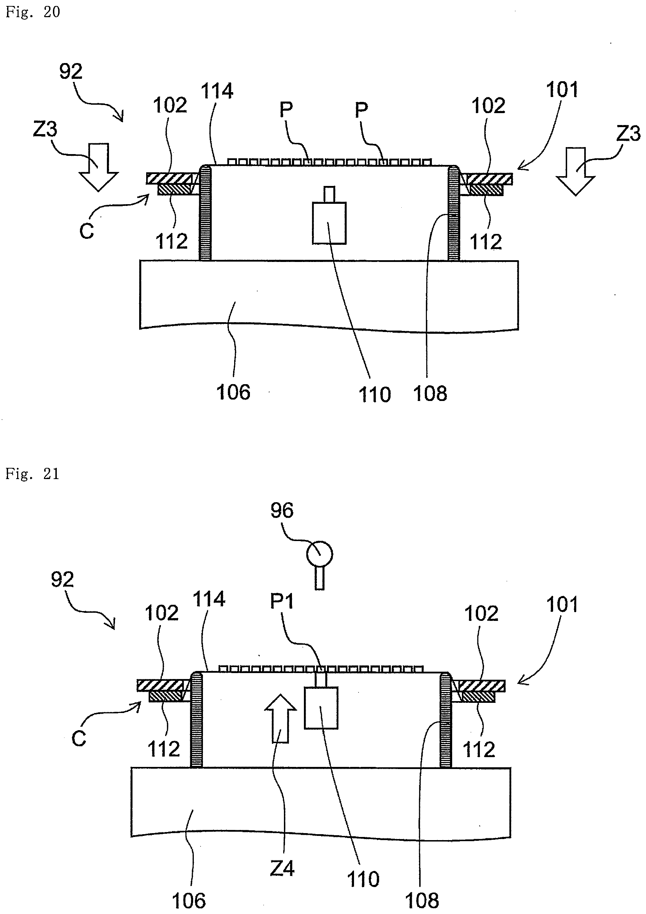

As shown in Fig. 20, the carrier frame retainer 102 presses the carrier frame 112 downward (arrow Z3). This allows the adhesive sheet 114 to spread radially outward, increasing the spacing between plurality of components P held by the adhesive sheet 114.

As shown in Fig. 21, the ejector 110 then rises (arrow Z4), pushing up the lower surface of the adhesive sheet 114 and forcing the component P1 upward at a predetermined position. By forcing the component P1 upward, the component P1 pickup operation of the pickup head 96 can be performed with high accuracy.

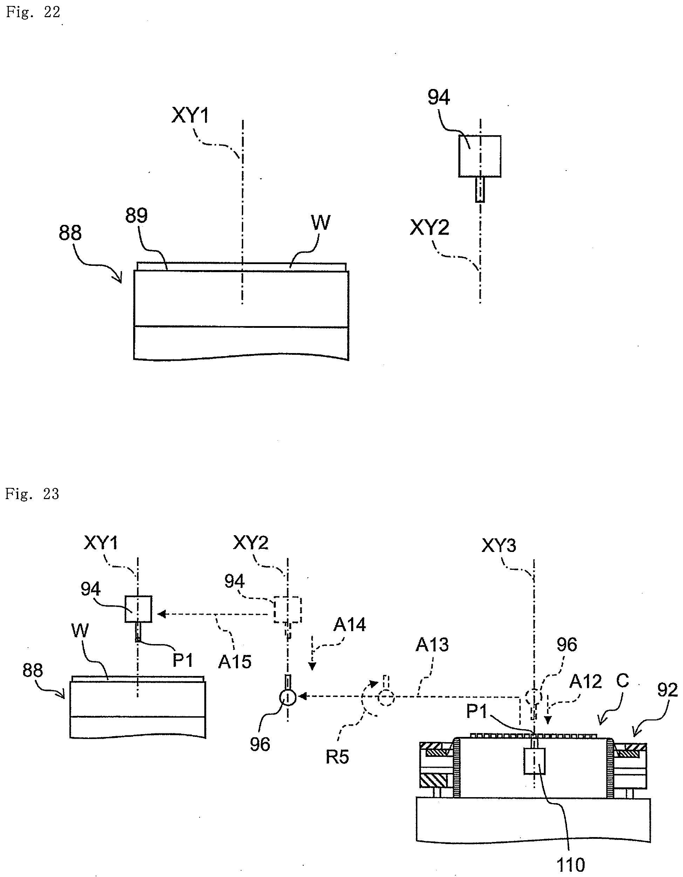

The bonding operation, in which a plurality of components P held on a component carrier C are individually bonded to a substrate W using the carrier holding table 92 and substrate holding table 90 described above, will be described with reference to Figs. 22 to 24.

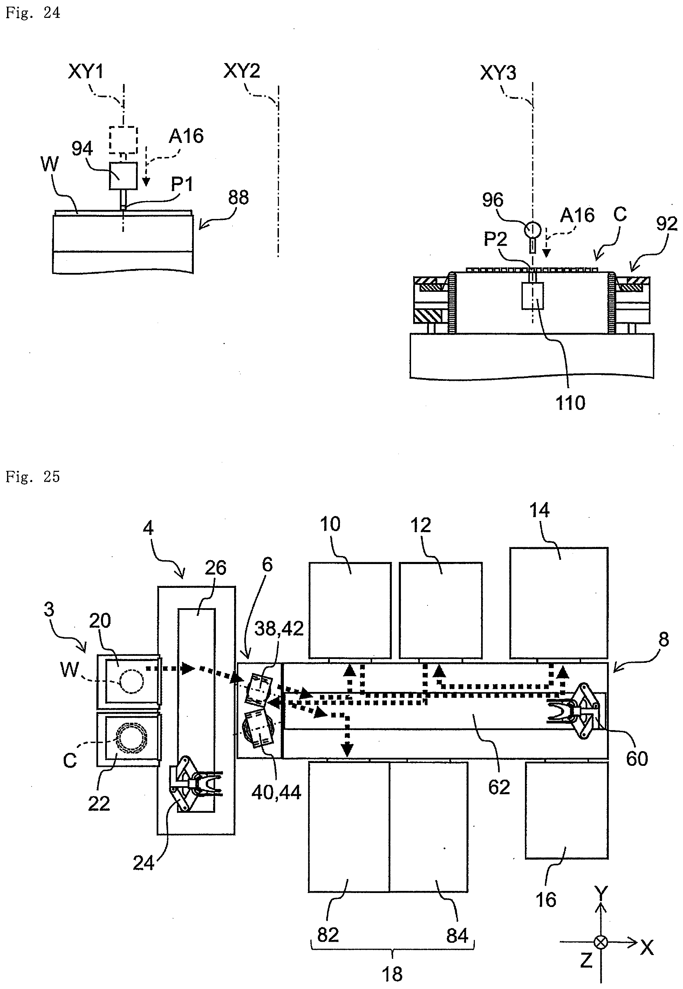

Fig. 22 is a longitudinal sectional view schematically showing a state in which the substrate W is held by the substrate holding table 88. Figs. 23 and 24 are longitudinal sectional views schematically showing a method of bonding a component P held by the component carrier C to the substrate W.

As shown in Fig. 22, the substrate transport device 87 shown in Fig. 1A transports the substrate W and places the substrate W on a holding surface 89 of the substrate holding table 88. The XY coordinate position of the substrate holding table 88 is adjusted so that the substrate W is disposed at a predetermined bonding work position XY1. The bonding head 94 is positioned at a component deliver position XY2 for delivering a component P between it and the pickup head 96.

As shown in Fig. 23, in a state where the ejector 110 forces a component P1 at a predetermined position upward in the component carrier C held on the carrier holding table 92, the pickup head 96 descends (arrow A12) to pick up the component P1. At this time, the XY coordinate position of the carrier holding table 92 is adjusted so that the component P1 is disposed at a predetermined pickup work position XY3.

The pickup head 96, having received the component P1, moves horizontally from the pickup work position XY3 toward the component deliver position XY2 (arrow A13), and reverses its orientation (arrow R5) in the process. This allows the component P1 to be oriented upward.

Subsequently, the bonding head 94 disposed above the pickup head 96 at the component deliver position XY2 descends (arrow A14) and attracts and holds the component P1 held by the pickup head 96. This allows the component P1 to be handed over to the bonding head 94 from the pickup head 96. The bonding head 94, having received the component P1, moves from the component deliver position XY2 to the bonding work position XY1 (arrow A15).

The bonding head 94, having moved to the bonding work position XY1, descends toward the substrate W held by the substrate holding table 88 (arrow A16), as shown in Fig. 24, and bonds the component P1 to the substrate W at the position corresponding to the bonding work position XY1. This completes the bonding process for the component P1.

While the bonding head 94 is mounting the component P1 onto the substrate W, the pickup head 96 performs the work of picking up a next component P2. To position the next component P2 at the pickup work position XY3, the lifting section 101 supporting the component carrier C is moved in the XY direction. The ejector 110 does not have the function of moving in the XY direction, and moves up and down independently of the lifting section 101 in a state where it is disposed at the pickup work position XY3 in advance.

By repeatedly performing the operations shown in Figs. 23 and 24, a plurality of components P held by the component carrier C can be individually bonded to a single substrate W.

In the bonding system 2 of this embodiment, when bonding the component P to the substrate W, hybrid bonding is performed, in which electrodes are directly bonded without using bonding aids such as solder. In order to perform hybrid bonding with high accuracy, the substrate W and components P are subjected to surface treatment before being brought into the bonding apparatus 18.

In this embodiment, a plurality of types of surface treatment modules 10, 12, 14, and 16 are provided as shown in Fig. 1A, and the transport robot 60 for the transport module 8 handling both the substrate W and the component carrier C is also provided. The transport robot 60 transports the substrate W and the component carrier C to each module to perform surface treatment, and then loads them into the bonding apparatus 18.

### (Substrate Processing Flow)

An example of a processing flow of the substrate W using the bonding system 2 of this embodiment will be described with reference to Figs. 25 to 27. Figs. 25 to 27 are plan views of the bonding system 2 that schematically show an example of processing flow of the substrate W.

In Figs. 25 to 27, the movement sequence of the substrate W is indicated by dotted arrows.

Fig. 25 shows the sequence of movement of the substrate W from when it is supplied by the load port 3 until it is loaded into the first bonding module 82 of the bonding apparatus 18.

### <Step of Loading into Bonding System and Temporary Placement Step>

As shown in Fig. 25, the transport robot 24 of the loading module 4 accesses the sealed container 20 mounted on the load port 3 and uses the hand 28 (Figs. 2 to 4) to remove one substrate W from the sealed container 20. The transport robot 24, having removed the substrate W, rotates horizontally and then hands over the substrate W to the first shelf 46 (Fig. 7) on the lower level of the first temporary placement stage 38 of the relay module 6 in an oblique orientation in plan view.

### <First Cleaning Step (First Surface Treatment Step)>

Subsequently, the transport robot 60 of the transport module 8 accesses the first temporary placement stage 38 and receives the substrate W in an oblique orientation in plan view. The transport robot 60, having received the substrate W, rotates horizontally and then moves horizontally in the +X-axis direction to access the surface treatment module 10, and hands over the substrate W to the surface treatment module 10. In the surface treatment module 10, cleaning treatment for the substrate W is performed using a liquid such as pure water or chemical solution.

### <Surface Modification Step (Second Surface Treatment Step)>

The substrate W, having undergone the cleaning treatment, is unloaded from the surface treatment module 10 and received by the transport robot 60. The transport robot 60, having received the substrate W, moves horizontally in the +X-axis direction to access the surface treatment module 14 and hands over the substrate W to the surface treatment module 14. In the surface treatment module 14, the substrate W undergoes surface modification treatment using plasma.

### <Second Cleaning Step (Third Surface Treatment Step)>

The substrate W, having undergone surface modification treatment, is unloaded from the surface treatment module 14 and received by the transport robot 60. The transport robot 60, having received the substrate W, moves horizontally in the -X-axis direction to access the surface treatment module 12 and hands over the substrate W to the surface treatment module 12. In the surface treatment module 12, the substrate W undergoes cleaning process using pure water.

### <Positioning Step>

The substrate W, having undergone the cleaning treatment, is unloaded from the surface treatment module 12 and received by the transport robot 60. The transport robot 60, having received the substrate W, moves horizontally in the -X-axis direction to access the third temporary placement stage 42 of the relay module 6, and hands over the substrate W to the third temporary placement stage 42 in an oblique orientation in plan view. The third temporary placement stage 42 positions the substrate W so that it is aligned to a predetermined orientation.

### <Step of Loading into Bonding Apparatus>

The transport robot 60 receives, in an oblique orientation in plan view, the substrate W positioned in a predetermined orientation on the third temporary placement stage 42. The transport robot 60, having received the substrate W, moves horizontally in the +X-axis direction to access the first bonding module 82 of the bonding apparatus 18, and loads the substrate W into the first bonding module 82.

According to the above flow, after cleaning and surface modification treatments are performed on the substrate W, the substrate W is aligned to a predetermined orientation on the third temporary placement stage 42, and then the substrate W is loaded into the first bonding module 82.

### <Bonding Step>

The substrate W loaded into the first bonding module 82 undergoes bonding process using a plurality of components P from the component carrier C loaded into the second bonding module 84. In this embodiment, when bonding a plurality of components P to the substrate W, the components P can be stacked in a plurality of layers. At this time, after the bonding process for the nth layer of components P is completed, and before performing the bonding process for the (n+1)th layer of components P, the substrate W is subjected to cleaning treatment.

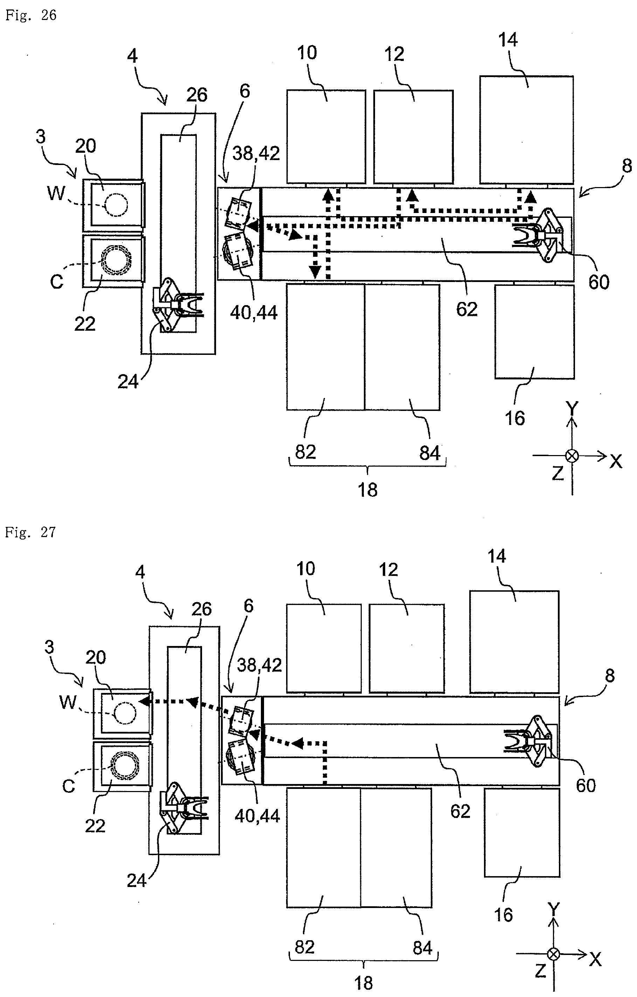

Fig. 26 shows the sequence of movements of the substrate W from the time the substrate W is unloaded from the first bonding module 82 to perform various surface treatments up to the time the substrate W is returned to the first bonding module 82, after the substrate W is loaded into the first bonding module 82 and a predetermined number of components P (for example, up to the nth layer component P) are bonded, and before the component P of the next layer (for example, the (n+1)th layer component P) is bonded.

As shown in Fig. 26, the transport robot 60 receives the substrate W unloaded from the first bonding module 82, and the transport robot 60 rotates horizontally to access the surface treatment module 10. Similar to the processing flow in Fig. 25, the transport robot 60 transports the substrate W so that the processes are executed in the following order: cleaning process in the surface treatment module 10 (first cleaning step), surface modification process in the surface treatment module 14 (surface modification step), cleaning process in the surface treatment module 12 (second cleaning step), positioning process on the third temporary placement stage 42 (positioning step), and process of supplying to the first bonding module 82 (step of loading into the bonding apparatus).

By executing the processing flow shown in Fig. 26 each time a component P in each layer is bonded, the process of bonding a plurality of layers of components P to the substrate W can be executed with high accuracy.

Fig. 27 shows the sequence of movement of the substrate W from the time the substrate W is unloaded from the first bonding module 82 after all the components P to be bonded to the substrate W are bonded, until it returns to the load port 3.

### <Step of Unloading from Bonding Apparatus and Temporary Placement Step>

As shown in Fig. 27, the transport robot 60 receives the substrate W unloaded from the first bonding module 82, and the transport robot 60 moves horizontally in the -X-axis direction to access the first temporary placement stage 38. The transport robot 60 then hands over the substrate W to the second shelf 48 (Fig. 7) on the upper level of the first temporary placement stage 38 in an oblique orientation in plan view.

### <Step of Unloading from Bonding System>

The transport robot 24 of the loading module 4 accesses the first temporary placement stage 38 and receives the substrate W in an oblique orientation in plan view. The transport robot 24, having received the substrate W, rotates horizontally and hands over the substrate W to the load port 3.

According to the processing flow shown in Fig. 27, the post-use substrate W, after the bonding process of the components P is completed, can be returned to the load port 3 and discharged to the exterior of the bonding system 2.

### (Component Carrier Processing Flow)

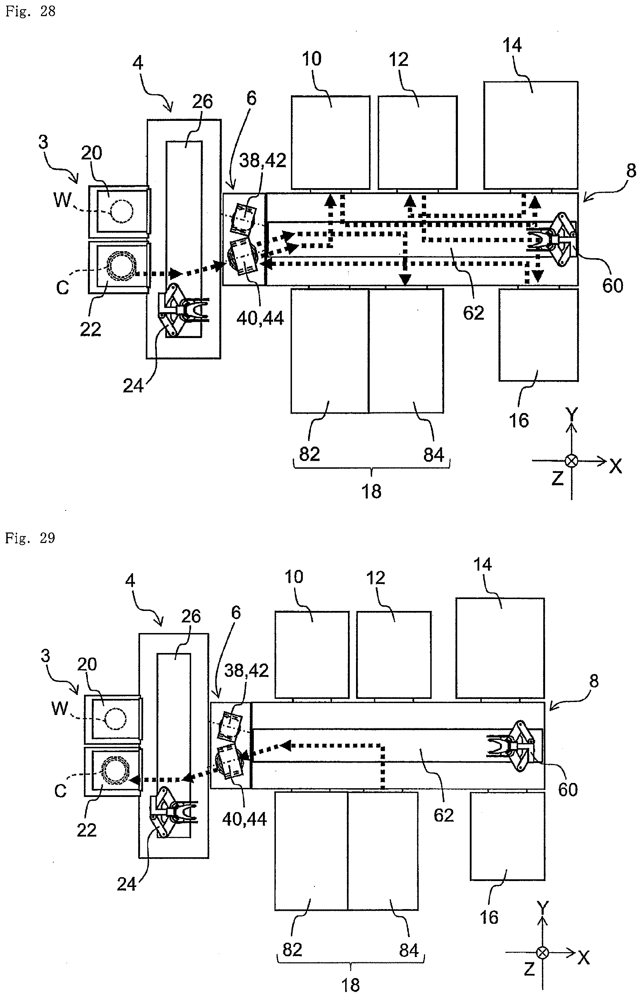

An example of processing flow of the component carrier C by the bonding system 2 of this embodiment will be described with reference to Figs. 28 and 29. Figs. 28 and 29 are plan views of the bonding system 2 schematically showing an example of processing flow of the component carrier C.

In Figs. 28 and 29, the movement sequence of the component carrier C is indicated by dotted arrows.

Fig. 28 shows the sequence of movement of the component carrier C from when it is supplied by the load port 3 until it is loaded into the second bonding module 84 of the bonding apparatus 18.

### <Step of Loading into Bonding System and Temporary Placement Step>

As shown in Fig. 28, the transport robot 24 of the loading module 4 accesses the sealed container 22 mounted on the load port 3 and uses the hand 32 (Figs. 2 to 4) to remove one component carrier C from the sealed container 22. The transport robot 24, having received the component carrier C, rotates horizontally and then hands over the component carrier C to the third shelf 50 (Fig. 8) on the lower level of the second temporary placement stage 40 of the relay module 6 in an oblique orientation in plan view.

### <First Cleaning Step (First Surface Treatment Step)>

The transport robot 60 of the transport module 8 accesses the second temporary placement stage 40 and receives the component carrier C in an oblique orientation in plan view. The transport robot 60, having received the component carrier C, rotates horizontally and then moves horizontally in the +X-axis direction to access the surface treatment module 10, and hands over the component carrier C to the surface treatment module 10. In the surface treatment module 10, the component carrier C undergoes cleaning treatment using a liquid such as pure water or chemical solution.

### <Surface Modification Step (Second Surface Treatment Step)>

The component carrier C, having undergone the cleaning treatment, is unloaded from the surface treatment module 10 and received by the transport robot 60. The transport robot 60, having received the component carrier C, moves horizontally in the +X-axis direction to access the surface treatment module 14 and hands over the component carrier C to the surface treatment module 14. In the surface treatment module 14, the surface modification treatment for the component carrier C is performed using plasma.

### <Second Cleaning Step (Third Surface Treatment Step)>

The component carrier C, having undergone the surface modification treatment, is unloaded from the surface treatment module 14 and received by the transport robot 60. The transport robot 60, having received the component carrier C, moves horizontally in the -X-axis direction to access the surface treatment module 12 and hands over the component carrier C to the surface treatment module 12. In the surface treatment module 12, the cleaning treatment for the component carrier C is performed using pure water.

### <Ultraviolet Irradiation Step (Fourth Surface Treatment Step)>

The component carrier C, having undergone the cleaning treatment, is unloaded from the surface treatment module 12 and received by the transport robot 60. The transport robot 60, having received the component carrier C, moves horizontally in the +X-axis direction to access the surface treatment module 16 and hands over the component carrier C to the surface treatment module 16. In the surface treatment module 16, the component carrier C is subjected to ultraviolet irradiation. This hardens the adhesive sheet 114 of the component carrier C, weakening the adhesive force of the components P.

### <Positioning Step>

The component carrier C, having undergone the ultraviolet irradiation treatment, is unloaded from the surface treatment module 16 and received by the transport robot 60. Upon receiving the component carrier C, the transport robot 60 moves horizontally in the -X-axis direction to access the fourth temporary placement stage 44 of the relay module 6, and hands over the component carrier C to the fourth temporary placement stage 44 in an oblique orientation in plan view. In the fourth temporary placement stage 44, positioning is performed so that the component carrier C is aligned to a predetermined orientation.

### <Step of Loading into Bonding Apparatus>

The transport robot 60 receives, in an oblique orientation in plan view, the component carrier C positioned in a predetermined orientation on the fourth temporary placement stage 44. Upon receiving the component carrier C, the transport robot 60 moves horizontally in the +X-axis direction to access the second bonding module 84 of the bonding apparatus 18, and loads the component carrier C into the second bonding module 84.

According to the above flow, after the cleaning treatment, surface modification treatment, and ultraviolet irradiation treatment are performed on the component carrier C, the component carrier C is aligned to a predetermined orientation on the fourth temporary placement stage 44 , and then supplied to the second bonding module 84.

### <Component Removal Step and Bonding Step>

In the second bonding module 84, a plurality of components P held on the component carrier C are sequentially removed by the pickup head 96, handed over to the bonding head 94, and then bonded to the substrate W. After all the components P are removed, the post-use component carrier C is unloaded from the second bonding module 84 and then discharged from the bonding system 2 to the exterior.

Fig. 29 shows the sequence of movement of the component carrier C from the time it is unloaded from the second bonding module 84 after all the components P to be removed are removed in the second bonding module 84, until it returns to the load port 3.

### <Step of Unloading from Bonding Apparatus and Temporary Placement Step>

As shown in Fig. 29, the transport robot 60 receives the component carrier C unloaded from the second bonding module 84, and the transport robot 60 moves horizontally in the -X-axis direction to access the second temporary placement stage 40. The transport robot 60 then hands over the component carrier C to the fourth shelf 52 (Fig. 8) on the upper level of the second temporary placement stage 40 in an oblique orientation in plan view.

### <Step of Unloading from Bonding System>

The transport robot 24 of the loading module 4 accesses the second temporary placement stage 40 and receives the component carrier C in an oblique orientation in plan view. Upon receiving the component carrier C, the transport robot 24 rotates horizontally and hands over the component carrier C to the load port 3.

According to the processing flow shown in Fig. 29, the post-use component carrier C from which the components P have been removed can be returned to the load port 3 and discharged to the exterior of the bonding system 2.

According to the above configuration and method, as a hybrid bonding system capable of directly bonding electrodes of the component P and substrate W, in particular, a highly efficient bonding system 2 capable of automatically transporting both component carrier C and substrate W can be built.

By using the transport robots 24 and 60 that can handle both the two types of transport targets, the component P and substrate W, the component P and substrate W to be transported can be transported efficiently, thereby implementing the bonding system 2 with high processing efficiency.

Furthermore, by providing the temporary placement module 6, the substrate W and component carrier C can be efficiently handed over between the loading module 4 and the transport module 8. In addition, by adding the positioning function for the component carrier C and substrate W to the relay module 6, the accuracy of the component bonding process in the bonding apparatus 18 can be improved.

The number of component carriers C required for a single substrate W varies. For example, a single substrate W may require five component carriers C. The processing flows for substrate W shown in Figs. 25 to 27 and the processing flows for component carriers C shown in Figs. 28 and 29 can be executed at appropriate timings depending on a single substrate W and the number of component carriers C required for the single substrate W, and may even be executed in parallel.

### (Function and Effect 1)

The bonding system 2 of this embodiment comprises: the plurality of surface treatment modules 10, 12, 14, and 16 configured to perform surface treatment on a plurality of components P held on a component carrier C and to perform surface treatment on a substrate W to be bonded with the plurality of components P; the bonding apparatus 18 configured to bond the plurality of surface-treated components P individually to the surface-treated substrate W; and the transport module 8 configured to transport the component carrier C and the substrate W between the surface treatment modules 10, 12, 14, and 16 and the bonding apparatus 18, wherein the transport module 8 includes: the transport robot 60 having the hand 64 (first hand) for holding the substrate W and the hand 68 (second hand) for holding the component carrier C; and the robot transport table 62 configured to move the transport robot 60 along the X-axis direction (first direction).

According to such a configuration, the transport robot 60 can transport both the substrate W and the component carrier C, moving them between the surface treatment modules 10, 12, 14, and 16 and the bonding apparatus 18, thereby implementing the bonding system 2 with high processing efficiency. It should be noted that the system is not limited to including the surface treatment modules 10, 12, 14, and 16, and that it is sufficient to include a plurality of surface treatment modules, at least one of which is capable of processing the substrate W and at least one of which is capable of processing the component carrier C, thereby performing surface treatment on a plurality of components P held in the component carrier C, and surface treatment on the substrate W for bonding the plurality of components P.

Furthermore, in the bonding system 2 of this embodiment, the surface treatment modules 10, 12, and 14 and the bonding apparatus 18 are arranged on opposite sides with respect to the movement path of the transport robot 60 along the X-axis direction (first direction). According to such a configuration, the transport robot 60 rotates horizontally while being able to move in the X-axis direction, allowing the component carrier C and the component P to be easily handed over to the surface treatment modules 10, 12, and 14 and the bonding apparatus 18, which are arranged on opposite sides of the movement path of the transport robot 60. Note that it is sufficient provided that at least one surface treatment module, without being limited to the three surface treatment modules 10, 12, and 14, and the bonding apparatus 18 are arranged on opposite sides of the movement path of the transport robot 60 along the X-axis direction.

Furthermore, in the bonding system 2 of this embodiment, the surface treatment modules 10, 12, 14 and 16 perform surface treatment using any one of ultraviolet rays, plasma, and liquid. Such a configuration enables a plurality of types of surface treatments to be executed on the substrate W and component carrier C.

Furthermore, in the bonding system 2 of this embodiment, the component carrier C is a tape frame having an ultraviolet-curable adhesive sheet 114, and the surface treatment module 16 includes an ultraviolet irradiation device configured to emit ultraviolet rays. According to such a configuration, the surface treatment module 16 irradiates the adhesive sheet 114 of the tape frame with ultraviolet rays, weakening the adhesive force of the component P on the adhesive sheet 114, making it easier to pick up the component P from the tape frame. Note that it is sufficient as long as at least one surface treatment module, without limitation to the surface treatment module 16 alone includes the ultraviolet irradiation device that emits ultraviolet rays.

Furthermore, in the bonding system 2 of this embodiment, the bonding apparatus 18 includes the first bonding module 82 into which the substrate W is loaded and the second bonding module 84 into which the component carrier C is loaded, and the first bonding module 82 and the second bonding module 84 are arranged in the X-axis direction (first direction). According to such a configuration, by arranging the two types of bonding modules in the X-axis direction, the transport robot 60 can easily access each of the bonding modules 82 and 84 when it moves in the X-axis direction (first direction).

Furthermore, the bonding system 2 of this embodiment further includes the partition wall 81 that partitions the transport module 8 and the bonding apparatus 18 from each other, the partition wall 81 including the openings 82g and 84g for delivering the component carrier C and substrate W held by the transport module 8 to the bonding apparatus 18. According to such a configuration, particle ingress can be suppressed by partitioning off areas other than the openings 82g and 84g with the partition wall 81.

Furthermore, in the bonding system 2 of this embodiment, the openings 82g and 84g in the partition wall 81 include the first opening 82g through which the substrate W passes and the second opening 84g through which the component carrier C passes. According to such a configuration, by separating the first opening 82g through which the substrate W passes and the second opening 84g through which the component carrier C passes from each other, particle ingress can be further suppressed.

Furthermore, in the bonding system 2 of this embodiment, the hand 64 (first hand) and the hand 68 (second hand) are positioned offset from each other vertically, and each is movable forward and backward. According to such a configuration, the hand 64 and the hand 68 can hold the component carrier C and the substrate W, respectively, while preventing interference between the hand 64 and the hand 68.

Furthermore, in the bonding system 2 of this embodiment, the hand 64 (first hand) is positioned above the hand 68 (second hand). According to such a configuration, by positioning the component carrier C, which has a higher particle adhesion rate than the substrate W, below it, particle ingress caused by the component carrier C can be suppressed.

Furthermore, in the bonding system 2 of this embodiment, the substrate W is a wafer, and the component carrier C is a tape frame. Such a configuration enables execution of the bonding process that bonds the component P held on the tape frame to the wafer.

Furthermore, the bonding method of this embodiment comprises: performing the surface treatment on a plurality of components P held on a component carrier C; performing the surface treatment on a substrate W to be bonded with the plurality of components P; transporting the surface-treated substrate W to the bonding apparatus 18 with the hand 64 (first hand); transporting the surface-treated component carrier C to the bonding apparatus 18 with the hand 68 (second hand); bonding the plurality of surface-treated components P individually to the surface-treated substrate W using the bonding apparatus 18; removing, with the hand 64, the substrate W to which a plurality of components P have been bonded from the bonding apparatus 18; and removing, with the hand 68, the component carrier C from which the plurality of components P have been removed, from the bonding apparatus 18.

This method allows the transport robot 60 to transport both the substrate W and the component carrier C, enabling them to be loaded into and unloaded from the bonding apparatus 18, thereby implementing the bonding system 2 with high processing efficiency.

### (Function and Effect 2)

The bonding system 2 of this embodiment comprises: the loading module 4 configured to load a component carrier C holding a plurality of components P and to load a substrate W to be bonded with the plurality of components P; the relay module 6 onto which the component carrier C and substrate W received from the loading module 4 are placed; the transport module 8 configured to transport the component carrier C and substrate W placed on the relay module 6 along the X-axis direction (first direction); the surface treatment modules 10, 12, 14, and 16 configured to perform surface treatment on the plurality of components P held on the component carrier C and to perform surface treatment on the substrate W; and the bonding apparatus 18 configured to bond the plurality of surface-treated components P individually to the surface-treated substrate W, the transport module 8 transporting the component carrier C and substrate W between the surface treatment modules 10, 12, 14, and 16 and the bonding apparatus 18.

According to such a configuration, the transport module 8 can transport both the substrate W and the component carrier C, moving them between the surface treatment modules 10, 12, 14, and 16 and the bonding apparatus 18, thereby implementing the bonding system 2 with high processing efficiency. Note that it is sufficient to include at least one surface treatment module capable of processing the substrate W and at least one surface treatment module capable of processing the component carrier C, without being limited to including the surface treatment modules 10, 12, 14, and 16, thereby providing the surface treatment modules that perform surface treatment on a plurality of components P held on the component carrier C, and surface treatment on the substrate W for bonding the plurality of components P.

Furthermore, in the bonding system 2 of this embodiment, the relay module 6 includes the first temporary placement stage 38 onto which the substrate W is placed, and the second temporary placement stage 40 onto which the component carrier C is placed. According to such a configuration, the substrate W and the component carrier C can be placed in separate locations.

Furthermore, in the bonding system 2 of this embodiment, the first temporary placement stage 38 includes the first shelf 46 for placing the pre-use substrate W received from the loading module 4 and the second shelf 48 for placing the post-use substrate W to which a plurality of components P have been bonded, while the second temporary placement stage 40 includes the third shelf 50 for placing the pre-use component carrier C received from the loading module 4 and the fourth shelf 52 for placing the post-use component carrier C from which the plurality of components P have been removed. According to such a configuration, the pre-use substrate W and the post-use substrate W can be placed on the first temporary placement stage 38, and the pre-use component carrier C and the post-use component carrier C can be placed on the second temporary placement stage 40.

Furthermore, in the bonding system 2 of this embodiment, the first shelf 46 is disposed below the second shelf 48, and the third shelf 50 is disposed below the fourth shelf 52. According to such a configuration, since the substrate W and component carrier C tend to contain more particles before use than after use, placing the pre-use substrate W and component carrier C below can suppress particle ingress into the post-use substrate W and component carrier C.

Furthermore, in the bonding system 2 of this embodiment, the first temporary placement stage 38 is configured to deliver the substrate W to the transport module 8 in the first deliver direction A4 in plan view, and the second temporary placement stage 40 is configured to deliver the component carrier C to the transport module 8 in the second deliver direction A6 in plan view. According to such a configuration, the temporary placement stages 38 and 40 can deliver the substrate W and component carrier C, respectively, to the transport module 8 in their respective desired directions.

Furthermore, in the bonding system 2 of this embodiment, the first temporary placement stage 38 and the second temporary placement stage 40 are arranged in the Y-axis direction (second direction) that intersects the X-axis direction (first direction) in plan view, and the first deliver direction A4 and the second deliver direction A6 intersect with the X-axis direction. This configuration allows the temporary placement stages 38 and 40 to be arranged toward the transport module 8, ensuring smooth deliver of the component carrier C and the substrate W.

Furthermore, in the bonding system 2 of this embodiment, the relay module 6 further includes the positioning stages 42 and 44 for receiving the component carrier C and substrate W from the transport module 8 and positioning them in the predetermined deliver directions A9 and A10. According to such a configuration, by positioning the component carrier C and substrate W in the predetermined deliver directions A9 and A10 before loading them into the bonding apparatus 18, it becomes easier to keep the postures of the component carrier C and the substrate W constant in the bonding apparatus 18, leading to improved bonding accuracy.

Furthermore, in the bonding system 2 of this embodiment, the positioning stages 42 and 44 include the first positioning stage 42 for positioning the substrate W and the second positioning stage 44 for positioning the component carrier C. According to such a configuration, the substrate W and the component carrier C can be positioned on the different stages 42 and 44, respectively.

Furthermore, in the bonding system 2 of this embodiment, the positioning stages 42 and 44 are disposed below the first temporary placement stage 38 and the second temporary placement stage 40. This configuration can suppress particle ingress.

Furthermore, in the bonding system 2 of this embodiment, the loading module 4 includes: the transport robot 24 (first transport robot) having the hand 28 (first hand) for holding the substrate W and the hand 32 (second hand) for holding the component carrier C; and the robot movement table 26 (first robot movement table) configured to move the transport robot 24 in the Y-axis direction (second direction) that intersects the X-axis direction (first direction) in plan view. According to such a configuration, both the substrate W and the component carrier C can be transported by the transport robot 24.

Furthermore, in the bonding system 2 of this embodiment, the transport module 8 includes: the transport robot 60 (second transport robot) having the hand 64 (third hand) for holding the substrate W and the hand 68 (fourth hand) for holding the component carrier C; and the robot movement table 62 (second robot movement table) configured to move the transport robot 60 in the X-axis direction (first direction). According to such a configuration, both the substrate W and the component carrier C can be transported by the transport robot 60.

Furthermore, in the bonding system 2 of this embodiment, the surface treatment modules 10, 12, and 14 and the bonding apparatus 18 are arranged on opposite sides with respect to the movement path of the transport module 8 along the X-axis direction (first direction). According to such a configuration, the transport robot 60 rotates horizontally while being able to move in the X-axis direction, making it possible to easily deliver the component carrier C and the component P to the surface treatment modules 10, 12, and 14 and the bonding apparatus 18, which are arranged on opposite sides of the movement path of the transport robot 60. Note that it is sufficient provided that at least one surface treatment module, without being limited to the three surface treatment modules 10, 12, and 14, and the bonding apparatus 18 are arranged on opposite sides of the movement path of the transport robot 60 along the X-axis direction.

Furthermore, in the bonding system 2 of this embodiment, the substrate W is a wafer, and the component carrier C is a tape frame. According to such a configuration, the bonding process can be executed that bonds the component P held on the tape frame to the wafer.

Furthermore, the bonding method of this embodiment comprises: loading a component carrier C configured to hold a plurality of components P and a substrate W to be bonded with the plurality of components P using the loading module 4; placing the component carrier C and substrate W received from the loading module 4 using the relay module 6; transporting the component carrier C and substrate W placed on the relay module 6 along the X-axis direction (first direction) using the transport module 8; performing surface treatment on the plurality of components P held on the component carrier C and surface treatment on the substrate W using the surface treatment modules 10, 12, 14, and 16; and bonding the plurality of surface-treated components P individually to the surface-treated substrate W using the bonding apparatus 18, wherein the transport module 8 herein transports the component carrier C and substrate W between the surface treatment modules 10, 12, 14, and 16 and the bonding apparatus 18.

This method allows the transport module 8 to transport both the substrate W and the component carrier C, moving them between the surface treatment modules 10, 12, 14, and 16 and the bonding apparatus 18, thereby implementing the bonding system 2 with high processing efficiency.

### (Variants, Etc.)

Although in the above embodiment, the case has been described where the substrate W is a wafer and the component carrier C is a tape frame, such a case is not limiting, and the substrate W may be a different type of substrate from a wafer, and the component carrier C may be a different type of component carrier from a tape frame.

Furthermore, although in the above embodiment, the case has been described where three surface treatment modules 10, 12, and 14 are provided as the first surface treatment module, the number of the first surface treatment modules is not limited to three, but can be any number. Similarly, although the case has been described where one surface treatment module 16 is provided as the second surface treatment module, the number of the second surface treatment modules is not limited to one, but can be any number.

Furthermore, the specific surface treatment methods (cleaning treatment, surface modification treatment, ultraviolet irradiation treatment) in the surface treatment modules 10, 12, 14, and 16 may be appropriately changed according to the specifications, etc. of the substrate W and the component P. The surface treatment modules 10, 12, 14, and 16 are not limited to types that can treat both the substrate W and the component carrier C, but may also be surface treatment modules dedicated to the substrate or surface treatment modules dedicated to the component carrier.

Furthermore, although in the above embodiment, the case has been described where the layout of each module as shown in Fig. 1A is applied, such a case is not limiting, and the layout may be changed as appropriate, such as by changing the arrangement of surface treatment modules 10, 12, 14, and 16.

While the present disclosure has been fully described in relation to the preferred embodiment with reference to the accompanying drawings, various variations and modifications will be obvious to those skilled in the art. Such variations and modifications should be understood as being included within the scope of the present disclosure insofar as they do not depart from the scope of the appended claims. Furthermore, changes in combinations and sequences of elements in the embodiment can be implemented without departing from the scope and spirit of the present disclosure.

The above various variants may be combined as appropriate so that their respective effects can be achieved.

### INDUSTRIAL APPLICABILITY

The present disclosure is applicable to a bonding system and a bonding method for individually bonding a plurality of components held on a component carrier to a substrate.

### REFERENCE SIGNS LIST

- 2: bonding system
- 4: loading module
- 6: relay module
- 8: transport module
- 10, 12, 14, 16: surface treatment module
- 18: bonding apparatus
- 19: control unit
- 24: transport robot
- 26: robot movement table
- 28: hand
- 32: hand
- 60: transport robot
- 62: robot movement table
- 64: hand
- 68: hand
- C: component carrier
- P: component
- W: substrate

## Claims

1. A bonding system comprising:
a loading module configured to load a component carrier holding a plurality of components and to load a substrate to be bonded with the plurality of components;
a relay module onto which the component carrier and the substrate received from the loading module are placed;
a transport module configured to transport the component carrier and the substrate placed on the relay module along a first direction;
a surface treatment module configured to perform surface treatment on the plurality of components held on the component carrier and to perform surface treatment on the substrate; and
a bonding apparatus configured to bond the plurality of surface-treated components individually to the surface-treated substrate, wherein
the transport module transports the component carrier and the substrate between the surface treatment module and the bonding apparatus.

2. The bonding system of claim 1, wherein
the relay module includes:
a first temporary placement stage onto which the substrate is placed; and
a second temporary placement stage onto which the component carrier is placed.

3. The bonding system of claim 2, wherein
the first temporary placement stage has a first shelf for placing the pre-use substrate received from the loading module, and a second shelf for placing the post-use substrate on which the plurality of components have been bonded, and wherein
the second temporary placement stage has a third shelf for placing the pre-use component carrier received from the loading module, and a fourth shelf for placing the post-use component carrier from which the plurality of components have been removed.

4. The bonding system of claim 3, wherein
the first shelf is disposed below the second shelf, and the third shelf is disposed below the fourth shelf.

5. The bonding system of claim 2, wherein
the first temporary placement stage is configured to deliver the substrate to the transport module in a first deliver direction in plan view, and the second temporary placement stage is configured to deliver the component carrier to the transport module in a second deliver direction in plan view.

6. The bonding system of claim 5, wherein
the first temporary placement stage and the second temporary placement stage are arranged in a second direction that intersects the first direction in plan view, and wherein
the first deliver direction and the second deliver direction each intersect with the first direction.

7. The bonding system of claim 2, wherein
the relay module further includes a positioning stage for receiving the component carrier and the substrate from the transport module and positioning them in their respective predetermined directions.

8. The bonding system of claim 7, wherein
the positioning stage includes:
a first positioning stage for positioning the substrate; and
a second positioning stage for positioning the component carrier.

9. The bonding system of claim 7, wherein
the positioning stage is disposed below the first temporary placement stage and the second temporary placement stage.

10. The bonding system of claim 1, wherein
the loading module includes:
a first transport robot having a first hand for holding the substrate and a second hand for holding the component carrier; and
a first robot movement table configured to move the first transport robot in a second direction intersecting the first direction in plan view.

11. The bonding system of claim 1, wherein
the transport module includes:
a second transport robot having a third hand for holding the substrate and a fourth hand for holding the component carrier; and
a second robot movement table configured to move the second transport robot in the first direction.

12. The bonding system of claim 11, wherein
at least one surface treatment module and the bonding apparatus are arranged on opposite sides with respect to the movement path of the transport module along the first direction.

13. The bonding system of claim 1, wherein
the substrate is a wafer and the component carrier is a tape frame.

14. bonding method comprising:
loading a component carrier configured to hold a plurality of components and a substrate to be bonded with the plurality of components, by using a loading module;
placing the component carrier and the substrate received from the loading module, by using a relay module;
transporting the component carrier and the substrate placed on the relay module along a first direction, by using a transport module;
performing surface treatment on the plurality of components held on the component carrier and surface treatment on the substrate, by using a surface treatment module; and
bonding the plurality of surface-treated components individually to the surface-treated substrate, by using a bonding apparatus, wherein
the transport module transports the component carrier and the substrate between the surface treatment module and the bonding apparatus.
